# EUROPEAN PATENT SPECIFICATION

(11) **EP 3 376 751 B1**
(45) Date of publication and mention of the grant of the patent: **21.04.2021**
(21) Application number: 16863702.3
(22) Date of filing: 14.11.2016
(51) Int. Cl.: H04N 5/225, H01L 23/00

(54) **CAMERA MODULE, ELECTRICAL SUPPORT THEREOF, AND ASSEMBLING METHOD THEREFOR**
KAMERAMODUL, ELEKTRISCHE STÜTZE DAFÜR UND MONTAGEVERFAHREN DAFÜR
MODULE DE CAMÉRA, SUPPORT ÉLECTRIQUE ASSOCIÉ ET PROCÉDÉ DE MONTAGE ASSOCIÉ

(30) Priority: 13.11.2015 CN 201510778437; 16.11.2015 CN 201510784845; 01.12.2015 CN 201510867694; 22.02.2016 CN 201610096941; 23.02.2016 CN 201610099510
(43) Date of publication of application: 19.09.2018
(73) Proprietor: Ningbo Sunny Opotech Co., Ltd., Ningbo, Zhejiang 315400 (CN)
(72) Inventor: WANG, Mingzhu, Ningbo Zhejiang 315400 (CN); ZHANG, Baozhong, Ningbo Zhejiang 315400 (CN); ZHAO, Bojie, Ningbo Zhejiang 315400 (CN); CHEN, Feifan, Zhejiang 315400 (CN); GUO, Nan, Ningbo Zhejiang 315400 (CN); DING, Liang, Zhejiang 315400 (CN); HUANG, Zhen, Ningbo Zhejiang 315400 (CN); JIANG, Heng, Ningbo Zhejiang 315400 (CN); CHEN, Zhenyu, Ningbo Zhejiang 315400 (CN); WU, Ye, Ningbo Zhejiang 315400 (CN)
(74) Representative: Gong, Jinping
(86) International application number: PCT/CN2016/105724
(87) International publication number: WO 2017/080526

(56) References cited:
- EP-A2- 1 523 042
- WO-A1-2011/084900
- CN-A- 102 291 525
- CN-A- 103 402 049
- CN-A- 103 576 417
- CN-A- 105 472 216
- CN-A- 105 611 135
- CN-A- 105 744 127
- CN-U- 204 332 960
- GB-A- 2 438 303
- US-A1- 2006 208 182
- US-A1- 2010 328 525
- US-A1- 2011 267 534
- US-A1- 2011 286 736
- US-A1- 2014 035 165
- US-A1- 2014 092 296
- US-A1- 2014 253 794
- US-A1- 2015 062 424
- US-B2- 7 782 391

## Description

### FIELD OF INVENTION

The present invention relates to a field of camera module, and more particularly to a camera module, an electrical holder and an assembling method thereof.

### DESCRIPTION OF RELATED ARTS

With a rapid development of electronic products, the electronic products become a vital product in daily lives. In order to meet the market demands of space-saving and portability, the electronic products are designed with a tendency of lightness and thinness, such that the size of each electronic component must be minimized. Therefore, the size of the camera module must also be minimized with lightness and thinness features correspondingly to be installed into the electronic product.

Camera module structure formed by the traditional COB (chip on board) manufacturing process comprises a printed circuit board, a photosensitive chip, a lens base, a driver, and a lens assembly, wherein each of the electronic components of the camera module structure is arranged on a surface of the circuit board, and the electronic components are not overlapped with each other. Based on the high requirement of pixel and extra-thin structure of the camera module, the image quality for the camera module is highly expected. Therefore, the packaging and assembling process of the camera module will be complicated and the specification of each electronic component will be relatively high. Meanwhile, for higher pixel of the camera module, the chip area thereof becomes relatively bigger. The number of electronic components, such as the drivers, resistors, and capacitors, will be increased. As a result, the overall size of the camera module will be relatively increased.

The conventional mobile phone module package is conflict with the trend of phone camera module, which is desirable for its thinness and miniaturization features, and thus it is necessary to propose a new type of compact packaging technology to meet the demands of product development.

Although such camera module has been widely used in the market, this kind of camera module still has many drawbacks.

Firstly, during the manufacturing process of the camera module, after the camera module is assembled, the driver of the camera module needs to be soldered to the circuit board to ensure the driver to be electrically connected. As a result, the manufacturing process is complicated. The soldering step will also cause other issues. For example, the product quality might be adversely influenced by the soldering quality. Moreover, this soldering connection by soldering the protruded conductor is not solid, and thus would be easily damaged during an operation or maintenance process.

Secondly, since the base is provided between the drivers, the electrical connection between the circuit and the drivers must be extended through the base, and thus will take up space and weaken the engagement between the circuit and the drivers.

Furthermore, through the conventional manufacturing process, the connecting wires for externally connecting between the circuit and the driver are vulnerable to the external environment, such as dust, etc., and thus would affect the quality of the entire camera module and reduce the service life of the entire camera module.

Furthermore, in order to provide a better supporting function of the base, the size of the base must be increased to provide a larger supporting area. Therefore, the overall size of the camera module will become larger as well. If the size of the camera module is reduced by reducing the size of the base, the supporting function of the base will be affected.

Furthermore, the circuit board of the conventional camera module is mounted on a bottom portion of the camera module, wherein the energy consuming components, such as the driver and the photosensitive chip, are arranged in a relatively far distance from the circuit board. In other words, more wires are required to be used in the camera module for electrical connection, and the design of the circuit configuration for the electrical components is more complicated. As a result, the occupying space of the circuit cannot be reasonably utilized. That is to say, if the circuit configuration and the electrical components are reasonably re-designed, the occupying space of the circuit can be effectively minimized. Then, the dimension of the camera module can be further minimized. Of course, the dimension, such as the width or thickness, of the camera module can be selectively adjusted to meet the market demands.

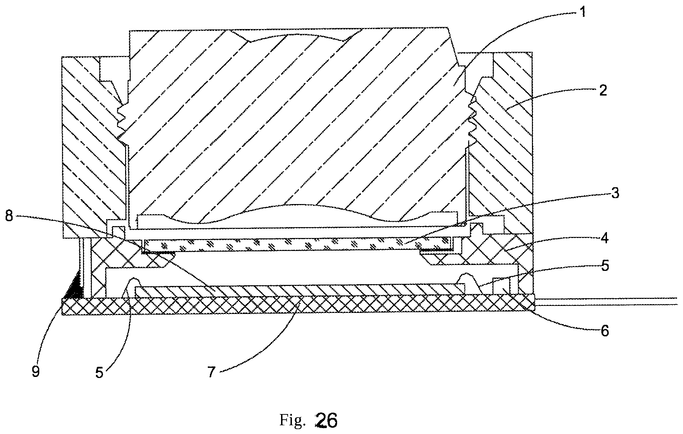

Reference is now made to Figure 26, which illustrates a conventional camera module comprising an optical lens 1, a motor 2, an optical filter 3, a base 4, at least one metal wire 5, a drive control member 6, a circuit board 7, a photosensitive chip 8, at least one motor solder joint 9 and a conductor used for electrically connecting the motor 2 and the circuit board 7. The photosensitive chip 8 is attached to the top surface of the circuit board 7. The metal wire 5, such as copper wire, is used to connect the photosensitive chip 8 and the circuit board 7 by wire bonding. The optical filter 3 is attached to the base 3 or the optical lens 1. After the camera module is assembled, the motor pins are soldered to electrically connect to the motor 2 and the circuit board 7. Therefore, the circuit board 7 can power the motor 2 and further control the operation of the motor 2.

Although such camera module has been widely used in the market, this camera module still has many drawbacks.

Firstly, the motor 2 has a protruded conductor which is electrically connected to the circuit board 7, so that the motor 2 is electrically connected to the circuit board 7. The conductor is connected to the circuit board 7 through the solder joint 9. The process for connecting the motor 2 and the circuit board 7 through a protruded conductor is complicated, and causes many other issues, for example, the product quality might be influenced by the soldering quality. Moreover, this soldering connection by soldering the protruded conductor is not solid, and thus would be easily damaged during an operation or maintenance process.

Furthermore, the circuit board 7 and the photosensitive chip 8 are connected by the metal wire 5. Such electrical connection is not secured. In addition, the base 4 needs to provide a relative large protection space for the metal wire 5 to be securely set. In other words, the size of the base 4 will be increased. Accordingly, the size of the entire camera module will also be increased.

Furthermore, the conductor, the metal wire 5 and the drive control module 6 are vulnerable to the external environment, such as dust, etc., and thus will affect the quality of the entire camera module and reduce the service life of the entire camera module.

As mentioned above, both of the connection between the circuit board 7 and the photosensitive chip 8 as well as the connection between the motor 2 and the circuit board 7 take certain large space and are difficult to get good protection. Meanwhile, the base 4 has a large size to be connected with the circuit board 7, the photosensitive chip 8 and the motor 2. However, it can achieve electrical connection between the circuit board 7 and the motor 2 and between the circuit board 7 and the photosensitive chip 8. In addition, the base 4 is hardly able to provide enough protection to other electronic components in the camera module. It cannot provide a full protection from dust or other contaminants.

US 2014/035165 A1 provides a pierced substrate on chip module structure comprising a first substrate. A chip is configured on the first substrate, with a first contact pad and a sensing area. A second substrate is disposed on the first substrate and the chip, with a concave structure, at least one through hole structure and a second contact pad, wherein the chip is disposed within the concave structure, and the first contact pad and the sensing area are exposed over the through hole structure.

US 2006/208182 A1 discloses a solid-state image sensing device, having a printed board; a solid-state image sensing element fixed to the printed board; and a light-transmitting lid section fixed to the solid-state image sensing element so as to cover an image sensing area. The printed board has a bore which penetrates through the printed board in a thickness direction thereof, at least a part of the light-transmitting lid section is fitted in the bore, and connecting terminals of the printed board are connected to connecting terminals of the solid-state image sensing element.

US 2010/328525 A1 discloses a camera module and a method of manufacturing the camera module. The camera module includes a substrate having an opening through which light passes, a circuit pattern for transmitting an electrical signal, and first and second terminals connected to the circuit pattern; an image sensor combined with the substrate so as to receive the light through the opening, and electrically connected to the first terminals; a lead frame disposed around the image sensor and electrically connected to the second terminals of the substrate; a housing combined on a surface of the substrate opposite to another surface on which the image sensor and the lead frame are combined; and a lens disposed in the housing.

US20140253794A1 discloses a camera module using an embedded-component substrate, in which a recessed portion that has a greater depth than the thickness of an imaging device is disposed on the surface of the embedded-component substrate. An imaging device is bonded to a bottom of the recessed portion such that an opening is present between the top surface of the imaging device and the top surface of the embedded-component substrate. Connection pads on the imaging device are connected to conductor pads disposed on the surface (top surface) of the embedded-component substrate by bonding wires that go through the opening.

### SUMMARY OF THE PRESENT INVENTION

In order to obviate at least some of the shortcomings of the prior arts, the present invention provides an electrical holder for at least a camera module according to claim 1. Some features of optional or preferred embodiments are recited in the dependent claims.

The invention advantageously proposes a camera module and an electrical holder thereof, wherein the camera module does not contain any conventional base structure.

Another advantage of the invention is to provide a camera module and an electrical holder thereof, wherein the electrical holder integrates with the circuit board and the base to replace the base of the conventional camera module.

Another advantage of the invention is to provide a camera module and an electrical holder thereof, wherein the electrical holder is arranged to electrically connect with the electronic components of the camera module, such as, the chip, the driver and the like.

Another advantage of the invention is to provide a camera module and an electrical holder thereof, wherein the electrical holder can also support the optical filter of the camera module.

Another advantage of the invention is to provide a camera module and an electrical holder thereof, wherein the electrical holder can also support the driver of the camera module.

Another advantage of the invention is to provide a camera module and an electrical holder thereof, wherein the shape of the electrical holder is selectively configured according to different electronic components of the camera module.

Another advantage of the invention is to provide a camera module and an electrical holder thereof, wherein the electrical holder is formed with a compact structure to minimize the size of the camera module.

Another advantage of the invention is to provide a camera module an electrical holder thereof, wherein the electrical conductors and the electrical elements are pre-set at the main body of the electrical holder to form a circuit, such that the circuit is arranged within the electrical holder.

Another advantage of the invention is to provide a camera module and an electrical holder thereof, wherein the thickness of the electrical holder is minimized to fit in the camera module so as to make the electronic products thinner and lighter.

Another advantage of the invention is to provide a camera module and an electrical holder thereof, wherein the structure and the shape of the electrical holder is specifically configured for fitting different components of the camera module to minimize the size of the entire camera module.

Another advantage of the invention is to provide a camera module and an electrical holder thereof, wherein the size of the camera module is minimized with lightness and thinness.

Another advantage of the invention is to provide a camera module and an electrical holder thereof, wherein the camera module has no lens base structure and the cost thereof is reduced.

Another advantage of the invention is to provide a camera module and an electrical holder thereof, wherein the circuit of the camera module is embedded in the main body of the electrical holder to omit the circuit board attachment in the manufacturing process for the camera module, so as to simplify the process step and save the assembling cost.

Another advantage of the invention is to provide a camera module and an electrical holder thereof, wherein the camera module has a solid structure.

Another advantage of the invention is to provide a camera module and an electrical holder thereof, wherein the resistance, capacitance and driver chip device of the camera module are embedded in the electrical holder to prevent the camera module from being contaminated by the soldering resist and dust or from being shorted by solder, water and other contaminants and to improve the yield of product.

Another object of the present invention is to provide a camera module with an electrical holder, wherein the metal pieces of the electrical holder are interconnected, when the motor is attached to the electrical holder, and the circuit board of the camera module is able to connect with the motor directly, such as by using conductive adhesive to substitute the soldering process for mounting the motor to the circuit process.

Another object of the present invention is to provide a camera module with an electrical holder, wherein the camera module is suitable for flip chip method, and the photosensitive chip of the camera module can be attached to the electrical holder by using a flip chip method without a wire bonding process.

Another object of the present invention is to provide a camera module with an electrical holder, wherein the connecting method of the photosensitive conductive chip and the photosensitive chip pad of the camera module can be but not limited to ACP (anisotropic conductive paste), ultrasonic welding, thermo-compression bonding, reflow soldering, and etc.

Another object of the present invention is to provide a camera module with an electrical holder, wherein the resistors, capacitors and other electronic components of the camera module are embedded in the electrical holder which can prevent the module from getting dirty due to solder resist, dust, etc. so as to efficiently improve the product quality.

Another object of the present invention is to provide a camera module with an electrical holder, wherein the production of the camera module can use imposition manner which is suitable for high efficient massive production.

Another object of the present invention is to provide a camera module with an electrical holder, wherein the electrical holder substitutes the base in conventional camera module to reduce the inclination of module caused by the base so as to improve the product quality.

Another object of the present invention is to provide a camera module with an electrical holder, wherein the camera module has a small overall dimension, wherein the height of the camera module can be reduced 0.25 mm compared with the conventional COB packaging method and the overall dimensions can be reduced more than 0.5 mm.

Another object of the present invention is to provide a camera module with an electrical holder, wherein the camera module manufacturing process is simplified, and the motor is directly attached to the circuit board, which reduces the soldering process, shortens the production cycle and reduces production costs.

Another object of the invention is to provide a camera module and an electrical holder thereof, which can increase market competitiveness of the electronic product employing the camera module, especially increase its competitiveness in the high-end market and the market competitiveness of the corresponding electronic products.

Another object of the present invention is to provide a camera module with an electrical holder, wherein the electrical holder has strong market competitiveness, thus enhances the market competitiveness of the camera module using the electrical holder, and further enhances the market competitiveness of the electronic equipment using the camera module in high-end products market.

Another object of the present invention is to provide a camera module with an electrical holder, wherein the electrical holder is provided with a buffer structure, enabling the elements to be mounted on the electrical holder with buffering.

Another object of the present invention is to provide a camera module with an electrical holder, wherein the buffer structure is evenly distributed on the surface of the electrical holder to ensure that the elements to be mounted have uniform force applied thereon, and thus are mounted smoothly.

Another object of the present invention is to provide a camera module with an electrical holder, wherein the buffer structure buffers the pressure on the electrical elements asit is mounted to the electrical holder, and thus enhances the pressure tolerance to pressure of the electrical holder.

Additional advantages and features of the invention will become apparent from the following description , and may be realized by means of the instrumentalities and combinations particularly pointed out in the appended claims.

According to the present invention, an electrical holder implementation is provided. The electrical holder is used as one of the components of a camera module. The electrical holder comprises a main body and a circuit. The circuit is provided at the main body. The circuit is electrically connected with a photosensitive chip. The photosensitive chip is provided at and supported by an inner side of the electrical holder.

In some embodiments, the electrical holder comprises a plurality of connecting elements electrically connected with the circuit.

In some embodiments, the main body has a step-stair configuration.

In some embodiments, the circuit comprises a plurality of electrical elements and a plurality of electrical conductors, wherein the electrical conductors are electrically connected with the electrical elements, wherein the electrical elements are embedded in the main body.

In some embodiments, the electrical holder has a through hole, wherein the photosensitive chip is provided in the through hole. Alternatively, the electrical holder has an indented groove, wherein the photosensitive chip is installed in the indented groove.

In some embodiments, each of the electronic components is selected from the group including resistance, capacitance, transistor, converter, diode, driver chip, and so on

In some embodiments, the electrical holder further comprises a plurality of electronic components provided on a surface thereof in a protruding manner, wherein each of the electronic components is selected from the group including resistances, capacitances, transistor, converter, diode, drive chips, and etc.

In some embodiments, the camera module is a fixed-focus camera module, wherein the electrical holder further comprises a lens holder supported at a first holder portion of the electrical holder to receive an optical lens of the camera module, wherein the circuit is embedded in the main body and is further extended to be embedded in the lens holder.

In some embodiments, the camera module is a zoom camera module having a motor.

In some embodiments, the connecting elements comprises a plurality of chip connectors for electrically connecting the photosensitive chip with the circuit, wherein the electric connection method between the photosensitive chip and the circuit is selected from the group including soldering, anisotropic conductive paste, ultra sonic press, UV exposure, X-ray exposure, conductive glue, hot pressing, and so on.

In some embodiments, the connecting elements comprise a plurality of board connectors for electrically connecting the flexible circuit board of the camera module with the circuit of the camera module, wherein the electric connection method between the flexible circuit board and the circuit is selected from the group including soldering, anisotropic conductive paste, ultra sonic press, UV exposure, X-ray exposure, conductive glue, hot pressing, and so on.

In some embodiments, the connecting elements comprises a plurality of different connectors for electrically connecting different electronic components of the camera module with the circuit, wherein the electric connection method between the flexible circuit board and the circuit is selected from the group including soldering, anisotropic conductive paste, ultra sonic press, UV exposure, X-ray exposure, conductive glue, hot pressing, and so on.

In some embodiments, the circuit is embedded in the lens holder and the main body, wherein the electric connection method between the lens holder and the main body is selected from the group including soldering, anisotropic conductive paste, ultra sonic press, UV exposure, X-ray exposure, conductive glue, hot pressing, and so on.

In some embodiments, each of the connecting elements can be embodied as a bonding pad or a pin.

In some embodiments, the main body of the electrical holder comprises a first holder portion and a second holder portion, wherein an inner side of the first holder portion and the top side of the second holder portion form a first indented groove, and the second holder portion has a second indented groove.

In some embodiments, the chip connectors of the camera module are provided in an inner surface of the second holder portion.

In some embodiments, the main body of the electrical holder further comprises a third holder portion, wherein the third holder portion is inwardly indented with respect to the second holder portion, and the chip connectors connected with the photosensitive chip are provided on a top side of the third holder portion.

In some embodiments, an inner side of the second holder portion has a second indented groove, wherein the photosensitive chip is provided at the second indented groove.

In another embodiment, the main body further comprises a third holder portion, wherein the third holder portion is inwardly indented with respect to the second holder portion, a top side of the third holder portion forms a second indented groove, and an inner side of the third holder portion forms a third indented groove, the first indented groove, the second indented groove and the third indented groove form a through hole.

In some embodiments, the main body further comprises a third holder portion, wherein a top side of the third holder portion forms a second indented groove, the third holder portion forms a base of the electrical holder, the first indented groove and the second indented groove form an integrated groove, and the third holder portion forms a base and has a bottom serving as a bottom of the integrated groove.

In some embodiments, the chip connectors of the camera module are provided on an inner surface of the second holder portion or the top side of the third holder portion.

In some embodiments, the photosensitive chip is connected to at least one lead by COB type to be connected electrically with the connecting elements of the electrical holder, wherein the lead may be a gold wire, a copper wire, an aluminum wire, a silver wire, or an alloy wire having any material mentioned above.

In accordance with one other aspect of the invention, the present invention further provides such a camera module that is a fixed focus camera module, auto-focus camera module or zoom camera module to incorporate with the electrical holder.

In accordance with one other aspect of the invention, the present invention further provides an assembling method for a camera module, which comprises the following steps:
providing a photosensitive chip at an inner side of the electrical holder to position the photosensitive chip within the electrical holder;
positioning an optical lens along a photosensitive path of the photosensitive chip; and
electrically coupling the photosensitive chip with the electrical holder.

In accordance with one other aspect of the invention, the present invention further provides an intelligent electronic device, which comprises a device body and one or more camera modules disposed on the device body.

In accordance with one other aspect of the invention, the present invention further provides an electrical holder jointed board comprising a plurality of electrical holders integrally connected, wherein each of the electrical holders comprises a holder body and a circuit, the circuit is disposed in the holder body, the circuit can be electrically connected to a photosensitive chip of a camera module, and the photosensitive chip can be disposed inside the electrical holder and located inside the electrical holder.

In accordance with one other aspect of the invention, the present invention further provides an electrical holder having a buffer structure, which comprises a holder portion and a bottom portion, wherein the holder portion is connected to the bottom portion and adapted to supportably mount elements, and the bottom portion has a buffer structure which is projectingly disposed on the bottom portion so as to be press-fitted with buffering.

In accordance with some embodiments of the present invention, in the electrical holder having a buffer structure, the buffer structure comprises a plurality of buffer units, which are disposed on the bottom portion with a square arrangement.

In accordance with some embodiments of the present invention, in the electrical holder having a buffer structure, the buffer structure comprises a plurality of buffer units, which are disposed on the bottom portion with a grid-like arrangement.

In accordance with some embodiments of the present invention, in the electrical holder having a buffer structure, the buffer structure comprises a plurality of buffer units, which are disposed on the bottom portion in a radial arrangement.

In accordance with some embodiments of the present invention, in the electrical holder having a buffer structure, the buffer structure comprises a plurality of buffer units, which are disposed on the bottom portion in a ring-shaped arrangement.

In accordance with some embodiments of the present invention, in the electrical holder having a buffer structure, the buffer structure has a block structure.

In accordance with some embodiments of the present invention, in the electrical holder having a buffer structure, the buffer structure has an arc structure.

In accordance with some embodiments of the present invention, in the electrical holder having a buffer structure, the buffer structure has a stepped structure.

In accordance with some embodiments of the present invention, in the electrical holder having a buffer structure, the buffer structure has a hollow structure, and the hollow position is suitable for arranging electrical components.

In accordance with some embodiments of the present invention, in the electrical holder having a buffer structure, the bottom portion is provided with an electric element, and the buffer structure is provided along with the electric element.

In accordance with some embodiments of the present invention, in the electrical holder having a buffer structure, the cross-sectional area of the buffer structure is greater than the cross-sectional area of the electrical element.

In accordance with some embodiments of the present invention, in the electrical holder having a buffer structure, the electrical element is a bonding pad or a circuit pin.

In accordance with some embodiments of the present invention, in the electrical holder having a buffer structure, the holder portion is a boss-type holder structure and is adapted to supportably mount an optical filter.

In accordance with some embodiments of the present invention, in the electrical holder having a buffer structure, the bottom portion is adapted to arrange a photosensitive chip, and the buffer structure is located between the photosensitive chip and the bottom portion.

In accordance with some embodiments of the present invention, in the electrical holder having a buffer structure, the material of the buffer structure is selected from a group comprising: one or more of insulating polymers, conductive polymers, metals or metal oxides.

Those skilled in the art would understand that the above materials of the buffer structure are only examples, and do not limit the present invention. In practical applications, any material that can act as a buffer can be applied. In addition, the above shapes of the buffer structure are also only examples and do not limit the invention. In practical applications, it can be designed into a wide variety of shapes.

One other aspect of the present invention provides a camera module, comprising:
a lens assembly; and
a holder assembly, wherein the lens assembly is mounted on a front side of the holder assembly, and the holder assembly comprises the aforementioned electrical holder with a buffer structure.

In accordance with some embodiments of the present invention, in the camera module with a buffer structure, the holder assembly comprises an electrical element set, and the electrical element set is mounted on the electrical holder in a buffering supported manner by the buffer structure.

In accordance with some embodiments of the present invention, in the camera module with a buffer structure, the electrical element is a photosensitive chip, and the photosensitive chip and the electrical holder respectively include a corresponding circuit pin. The buffer structure is disposed along with the circuit pin.

In accordance with some embodiments of the present invention, in the camera module with a buffer structure, the height of the buffer structure is smaller than the gap between the photosensitive chip and the electrical holder after the circuit pin is pressed.

In accordance with some embodiments of the present invention, in the camera module with a buffer structure, the buffer structure is convexly disposed on the electrical holder by a single molding to form a limiting boss to prevent the tilt of the assembly due to the uneven press-fit force.

According to another respect of the present invention, an electrical holder is provided. The electrical holder is used in a camera module and comprises a holder body and a circuit. The circuit is provided on the holder body to form an integral structure, wherein the electrical holder integrates the functions of the base and the circuit board in conventional camera module. The circuit is embedded in the holder body. The circuit comprises a set of conductive members and a plurality of electronic components, wherein the conductive member is electrically connected with the electronic component in a default manner.

In one embodiment, the holder body further comprises a plurality of connecting elements which is electrically connected to the conductive members and the electronic components.

In one embodiment, the connecting element is provided on the surface of the holder body.

In one embodiment, the connecting element further comprises a plurality of photosensitive chip conductive members which are used in the camera module to electrically connect the photosensitive chip with the conductive member and the electronic component.

In one embodiment, the photosensitive chip conductive member is embodied as a photosensitive chip terminal pad.

In one embodiment, the connecting element further comprises a plurality of motor conductive members which is used in the motor of the camera module to electrically connect the motor with the conductive members and the electronic components.

In one embodiment, the motor conductive member is embodied as a motor terminal pad.

In one embodiment, the connecting element further comprises a plurality of flexible PCB conductive members which is used in a flexible PCB of the camera module to electrically connect the flexible PCB with the conductive members and the electronic components.

In one embodiment, the flexible PCB conductive member is embodied as a flexible PCB terminal pad.

In one embodiment, the electrical holder further comprises a plurality of electrical components, and the connecting element further comprises a plurality of electrical conductive members which is used to electrically connect the electrical component with the conductive member and the electronic component.

In one embodiment, the electrical conductive member is embodied as an electrical member terminal pad.

In one embodiment, the holder body has a first top surface, a first bottom surface, a second top surface and a second bottom surface, wherein a plurality of the connecting elements are provided on each of the first top surface, the first bottom surface, the second top surface or the second bottom surface of the holder body.

In one embodiment, the motor conductive member is provided on the second top surface.

In one embodiment, the photosensitive chip conductive member is provided on the first bottom surface.

In one embodiment, the flexible PCB conductive member is provided on the second bottom surface.

In one embodiment, the flexible PCB conductive member is provided on the second top surface.

In one embodiment, the electrical component and the electrical conductive member are provided on the first top surface.

In one embodiment, the electrical holder comprise a top groove, a through hole and a bottom groove, wherein the top groove and the bottom groove are used for assembling an optical filter and a photosensitive chip of the camera module, respectively.

In one embodiment, the holder body comprises a first holder portion and a second holder portion. The first holder portion has the first top surface and the first bottom surface. The second holder portion has the second top surface and the second bottom surface. The first top surface is indented with respect to the second top surface.

In one embodiment, the first top surface is in the same plane with the second top surface.

In one embodiment, the first bottom surface is indented with respect to the second bottom surface.

In one embodiment, the first bottom surface is in the same plane with the second bottom surface.

In one embodiment, wherein the holder body has a through hole, wherein the photosensitive chip and the filter lens are mounted on the opposite sides of the camera module, respectively.

In accordance with one other aspect of the invention, the present invention comprises a camera module which further comprises:
an optical lens;
a photosensitive chip; and
an electrical holder;
wherein the optical lens is located in an optical path of the photosensitive chip, and the electrical holder supports the photosensitive chip.

In one embodiment, the camera module further comprises a motor, wherein the optical lens is provided at the motor.

In one embodiment, the photosensitive chip is electrically connected to the circuit of the electrical holder.

In one embodiment, the camera module further comprises an optical filter, wherein the optical filter is provided between the optical lens and the photosensitive chip.

In one embodiment, the motor is soldered to or attached to the electrical holder.

In one embodiment, the photosensitive chip is provided on the bottom side of the holder body of the electrical holder and electrically connected to the circuit of the electrical holder. The photosensitive chip is assembled by using a flip chip method.

In one embodiment, the photosensitive chip and the electrical holder are assembled using possible method, such as ACP (anisotropic conductive paste), ultrasonic welding, thermo-compression bonding and reflow soldering.

In one embodiment, the camera module further comprises a flexible PCB, wherein the flexible PCB is provided on the top side or the bottom side of the holder body of the electrical holder, wherein the flexible PCB is electrically connected to the circuit of the electrical holder.

In accordance with one other aspect of the invention, the present invention comprises a manufacturing method of a camera module, which comprises the following steps:
providing a photosensitive chip on an electrical holder; and
installing an optical lens to locate the photosensitive chip in an optical path of the optical lens.

In one embodiment, the manufacturing method of the camera module further comprises the following step: providing a circuit on a holder body to form the electrical holder.

In one embodiment, the manufacturing method the camera module further comprises: forming laminated resin on a reinforcing member, such as reinforcing steel plate or a copper plate, to form a first holder portion, a second holder portion and a through hole, wherein the first holder portion and the second holder portion are integrally connected to form the holder body.

In one embodiment, the circuit is embedded in the holder body.

In one embodiment, the circuit comprises a plurality of conductors and a plurality of electrical components, wherein the electrical components are embedded in the holder body and the conductors are electrically connected with the electrical components.

In one embodiment, the manufacturing method of the camera module further comprises the following step: providing a plurality of photosensitive chip conductive members on the surface of the holder body, so that the circuit and the photosensitive chip are electrically connected.

In one embodiment, the manufacturing method of the camera module further comprises the following steps:
providing a plurality of motor conductive members on the surface of the holder body;
coupling the optical lens with a motor to form a zoom camera module; and
coupling the motor on the electrical holder and electrically connecting the circuit with the motor via at least one motor conductive member.

In one embodiment, the manufacturing method of the camera module further comprises the following steps:
forming a plurality of flexible PCB conductive members on the surface of the holder body; and
coupling the flexible PCB on the electrical holder and electrically connecting the circuit and the flexible PCB through the flexible PCB conductive members.

In one embodiment, the photosensitive chip is provided on the electrical holder, wherein the electrically connecting method of the photosensitive chip and the circuit is selected from the ACP (anisotropic conductive paste) and soldering.

In one embodiment, the flexible PCB is provided on the electrical holder, wherein the electrically connecting method of the flexible PCB and the circuit is selected from the ACP (anisotropic conductive paste) and soldering.

In one embodiment, the motor is provided on the electrical holder, wherein the electrically connecting method of the motor and the circuit is selected from the ACP (anisotropic conductive paste) and soldering.

In one embodiment, the photosensitive chip is attached to the electrical holder, wherein the electrically connecting method is selected from ACP (anisotropic conductive paste), ultrasonic welding, thermo-compression bonding and reflow soldering.

In one embodiment, the flexible PCB is attached to the electrical holder, wherein the electrically connecting method is selected from ACP (anisotropic conductive paste), ultrasonic welding, thermo-compression bonding and reflow soldering.

In one embodiment, the motor is attached to the electrical holder, wherein the electrically connecting method is selected from ACP (anisotropic conductive paste), ultrasonic welding, thermo-compression bonding and reflow soldering.

In one embodiment, the manufacturing method of the camera module further comprises the following steps:
providing a plurality of electrical conductive members on the surface of the holder body; and
providing a plurality of electrical components on the electrical holder, wherein the electrical components are electrically connected to the circuit by the electrical conductive members.

In one embodiment, the electrical components are attached to the electrical holder, wherein the electrically connecting method is soldering.

In one embodiment, the electrical components are selected from one or more of a resistor, a capacitor, and a driver element.

In accordance with one embodiment, the electrical holder has a through hole. The photosensitive chip is mounted to the electrical holder by a flip chip method, and the through hole provides an optical path for the lens and the photosensitive chip.

In accordance with one embodiment, the photosensitive chip is assembled on a bottom side groove of the bottom of the through hole of the electrical holder.

In accordance with one embodiment, it comprises: assembling an optical filter on the top of the electrical holder.

In accordance with one embodiment, it comprises: assembling the optical filter in a top groove of the top of the through hole of the electrical holder.

In accordance with one other aspect of the present invention, an electrical holder for a camera module is provided. The electrical holder comprises a holder body and a circuit integrated in the holder body. The holder body has a through hole, which has a bottom groove in the bottom of the through hole. A photosensitive chip of the camera module is adapted to be disposed in the bottom groove and is electrically connected to the circuit of the electrical holder.

In accordance with one other aspect of the present invention, an electrical holder joined board is provided. The electrical holder joined board comprises a plurality of electrical holders integrally connected, and each of the electrical holders comprises a holder body and a circuit integrated in the holder body. The holder body has a through hole, which has a bottom groove in the bottom of the through hole. A photosensitive chip of the camera module is adapted to be disposed in the bottom groove and is electrically connected to the circuit of the electrical holder.

In accordance with one other aspect of the present invention, a camera module with fixed focal is provided. The camera module comprises:
an optical lens;
a photosensitive chip; and
an electrical holder, including a through hole which has a bottom groove in the bottom of the through hole. A photosensitive chip of the camera module is adapted to be disposed in the bottom groove and is electrically connected to the circuit of the electrical holder. The through hole provides an optical path for the optical lens and the photosensitive chip.

Further, the optical lens is disposed on the top of the electrical holder, and the electrical holder supports the optical lens.

In accordance with one other aspect of the present invention, an autofocus camera module is provided. The camera module comprises:
an optical lens;
a photosensitive chip;
a motor, the optical lens is mounted on the motor; and
an electrical holder, supporting the motor, and the electrical holder comprises a through hole. The photosensitive chip and the motor are electrically connected to the electrical holder. The through hole provides an optical path for the optical lens and the photosensitive chip.

Further objects and advantages will become apparent from a consideration of the ensuing description and drawings.

These and other objectives, features, and advantages of the present invention will become apparent from the following detailed description, the accompanying drawings, and the appended claims.

### BRIEF DESCRIPTION OF THE DRAWINGS

FIG. 1 is a sectional view of a camera module according to the first preferred embodiment of the present invention.
FIG. 2 is a partially enlarged sectional view of the camera module according to the first preferred embodiment of the present invention.
FIG. 3 is an exploded perspective view of the camera module according to the first preferred embodiment of the present invention.
FIG. 4 is a sectional view of an alternative mode of the camera module according to the first preferred embodiment of the present invention.
FIG. 5 is a partially enlarged sectional view of the alternative mode of the camera module according to the first preferred embodiment of the present invention.
FIG. 6 is a sectional view of a camera module according to a second preferred embodiment of the present invention.
FIG. 7 is a partially enlarged sectional view of the camera module according to the second preferred embodiment of the present invention.
FIG. 8 is a sectional view of an alternative mode of the camera module according to the second preferred embodiment of the present invention.
FIG. 9 is a partially enlarged sectional view of the alternative mode of the camera module according to the second preferred embodiment of the present invention.
FIG. 10 is a sectional view of a camera module according to a third preferred embodiment of the present invention.
FIG. 11 is a flow chart illustrating a manufacturing method for the camera module according to the preferred embodiments of the present invention.
FIG. 12 illustrates that the electrical holder of the camera module according to the above preferred embodiments of the present invention is suitable for joined board process.
FIG. 13 shows a mobile phone having the camera module of the above preferred embodiments of the present invention.
FIG. 14 is a sectional view of a camera module with a buffer structure according to a fourth preferred embodiment of the present invention.
FIG. 15 is a schematic structural view of a buffer structure according to the above preferred embodiments of the present invention.
FIG. 16 is a top view of the buffer structure according to the above preferred embodiments of the present invention.
FIGS. 17A, 17B, 17C, and 17D are different layouts of a buffer structure according to the above preferred embodiments of the present invention.
FIGS. 18A, 18B, and 18C are schematic diagrams of different shapes of a buffer structure according to the above preferred embodiments of the present invention.
FIG. 19 is a sectional view of a camera module according to a fifth preferred embodiment of the present invention.
FIG. 20 is an assembly view of the camera module according to the above preferred embodiments of the present invention.
FIGS. 21A and 21B illustrate an electrical holder of the camera module according to the above preferred embodiments of the present invention.
FIGS. 22A and 22B illustrate an alternative mode of the electrical holder of the camera module according to the above preferred embodiments of the present invention.
FIGS. 23A and 23B illustrate another alternative mode of the electrical holder of the camera module according to the above preferred embodiments of the present invention.
FIGS. 24A and 24B illustrate another alternative mode of the electrical holder of the camera module according to the above preferred embodiments of the present invention.
FIGS. 25A and 25B illustrate a manufacturing method of the camera module according to the present invention.
FIG. 26 illustrates a camera module of the prior art.

### DETAILED DESCRIPTION OF THE PREFERRED EMBODIMENT

The following description is disclosed to enable any person skilled in the art to make and use the present invention. Preferred embodiments are provided in the following description only as examples and modifications will be apparent to those skilled in the art.

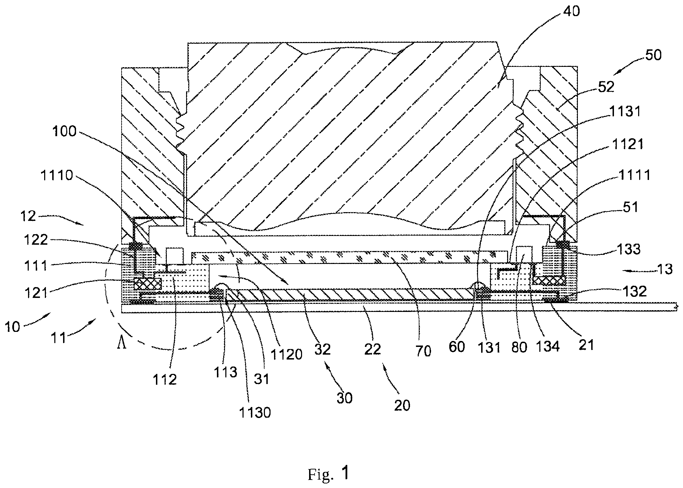

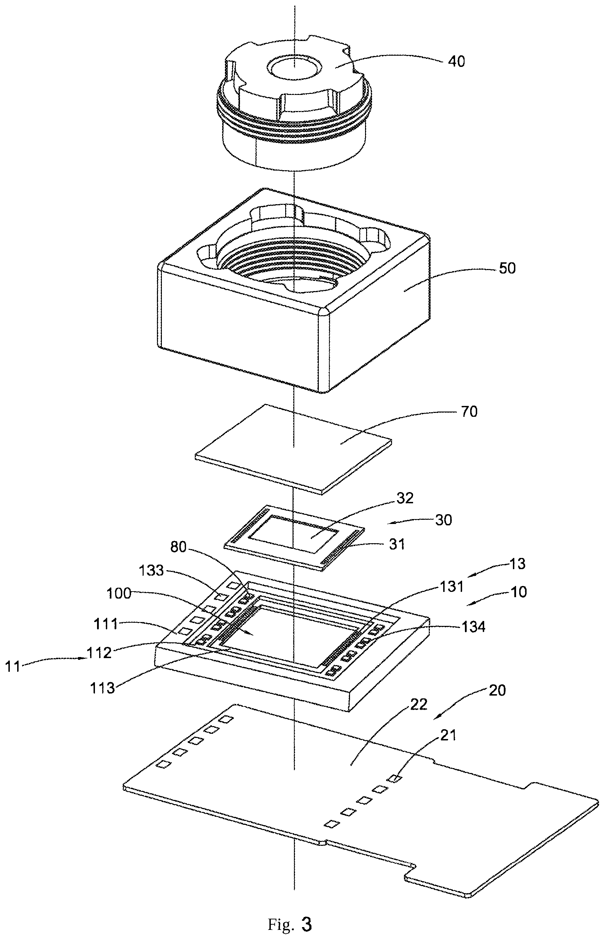

As shown in Figs. 1 and 3, a camera module according to a first preferred embodiment of the present invention is illustrated, wherein the camera module comprises an electrical holder 10, a flexible circuit board 20, a photosensitive sensor 30 such as a photosensitive chip, an optical lens 40, and a driver 50 such as a motor.

The optical lens 40 is operatively coupled at the driver 50, and the optical lens 40 can be actuated by the driver 50 to form an auto-focusing mechanism. The flexible circuit board 20 and the driver 50 are provided at two different sides of the electrical holder 10 to locate the optical lens 40 in a photosensitive path of the photosensitive chip 30. When the camera module is operated for capturing image, the light reflected by the object can be further accepted by the photosensitive chip 30 for photoelectric conversion after passing through the optical lens 40. That is to say, the flexible circuit board 20 and the driver 50 are connected with each other by the electrical holder 10. In other words, the electrical holder 10 serves as an integration of a base and a PCB in a conventional camera module, wherein the electrical holder 10 forms an assembling means for connecting the driver 50 and the optical lens 40 and forms an electrical connection means for electrically connecting to the driver 50, the photosensitive chip 30 and the flexible circuit board 20 with each other.

The electrical holder 10 comprises a main body 11, a circuit 12, a plurality of connecting elements 13, and a through hole 100. The circuit 12 is embedded in the main body 11, wherein the connecting elements 13 are provided on a surface of the main body 11. The circuit 12 comprises a plurality of electrical elements 121 and a plurality of electrical conductors 122, wherein the electrical conductors 122 are electrically connected with the electrical elements 121 in a predetermined manner. In addition, the electrical conductors 122 are electrically connected to the driver 50, the flexible circuit board 20 and the photosensitive chip 30 via the connecting elements 13, so as to pre-form a camera circuit of the camera module for activating and adjusting of the camera module. Each of the electrical elements 121 can be one of a resistor, a capacitor and a driver chip, and the like.

As shown in Figs. 1 and 3, according to the first preferred embodiment of the present invention, the main body 11 comprises a first holder portion 111, a second holder portion 112 and a third holder portion 113, wherein the first holder portion 111 forms an outer annular ring body. The second holder portion 112 is integrated with an inner side of the first holder portion 111, wherein the third holder portion 113 is integrated with an inner side of the second holder portion 112, such that the second holder portion 112 defines a middle ring body between the first holder portion 111 and the third holder portion 113. The through hole 100 is formed at the third holder portion 113, wherein the third holder portion 113 forms an inner annular ring body. It is worth mentioning that the three holder portions 111, 112 and 113 form a step-stair configuration to define a three-step structure, which is exemplary only and not intended to be limiting. For example, in some embodiments, the three holder portions 111, 112 and 113 may not have the step-stair configuration, or may have the step-stair configuration with a two-step structure. For example, the first holder portion 111, the second holder portion 112 and the third holder portion 113 can be integrated with each other by a stacking process, such as by configuring a laminated resin on a stiffening steel or copper plate to form the main body 11, and by arranging the circuit 12 to be embedded in the main body 11 to pre-form internal electrical lines thereat. The first holder portion 111 has a first top surface 1111. The second holder portion 112 has a second top surface 1121. The third holder portion 113 has a third top surface 1131. The second top surface 1121 is inwardly indented with respect to the first top surface 1111 to define a first indented groove 1110. The third top surface 1131 is inwardly indented with respect to the second top surface 1121 to define a second indented groove 1120 and a third indented groove 1130 is formed on the inner side of the third holder portion 113. In other words, the through hole 100 is defined by the first indented groove 1110, the second indented groove 1120 and the third indented groove 1130. In this exemplary preferred embodiment, the three holder portions 111, 112 and 113 define the top surface with three steps structure. The main body 11 of the electrical holder 10 of the camera module according to the first preferred embodiment has the three-step configuration, such that main body 11 not only provides a securely supporting structure to support the driver 50 and the optical lens 40 by the first holder portion 111 but also fully utilities the installation space for other camera components of the camera module.

For example, according to the first preferred embodiment, the camera module further comprises an optical filter 70 and a plurality of electronic components 80, wherein the optical filter 70 is used for filtering useless light to improve the image's quality. The optical filter 70 and the electronic components 80 are supportively supported on the second top surface 1121 of the second holder portion 112, such that the first indented groove 1110 can provide an arrangement space for the optical filter 70 and the electronic components 80. Each of the electronic components can be a resistor, a capacitor and a driver chip, and the like. It is worth mentioning that the electronic components 80 may be provided at other positions. In this aspect, the present invention is not limited. The optical filter 70 can be embodied as but not be limited to an IR filter or an infrared cut-off filter (IRCF).

The photosensitive chip 30 is located corresponding to the through hole 100. According to the first preferred embodiment of the present invention, the photosensitive chip 30 is provided in the third indented groove 1130 and is enclosed by the third holder portion 113 to fully utilize the space of the through hole 100. Furthermore, the photosensitive chip 30 may be further extended into the second indented groove 1120. It is worth mentioning that the setting location of the photosensitive chip 30 is exemplary only and not intended to be limiting. According to other embodiments of the present invention, the photosensitive chip 30 may be provided at other positions, for example, a top side of the third top surface 1131 of the third holder portion 113.

The photosensitive chip 30 is electrically connected to the electrical holder 10. Specifically, the photosensitive chip 30 comprises a plurality of photosensitive chip conductive elements 31 and a chip body 32, wherein the photosensitive chip conductive elements 31 are provided at the chip body 32. The connecting elements 13 of the electrical holder 10 comprises a plurality of chip connectors 131, wherein the photosensitive chip conductive elements 31 are electrically connected with the corresponding chip connectors 131 to achieve the electrical conduction and electrification between the photosensitive chip 30 and the electrical holder 10. According to the first preferred embodiment of the present invention, each of the photosensitive chip conductive elements 31 can be electrically connected with the corresponding chip connector 131 by traditional COB type. In other words, the photosensitive chip 30 is connected with a lead wire 60 (alternatively, a gold, copper, aluminum, or silver wire or alloy of any metal mentioned above) by traditional COB type to be electrically connected with the chip connectors 131 of the electrical holder 10. According to the first preferred embodiment of the present invention, the chip connectors 131 may be embodied as but not be limited to a pin or a bonding pad. In other words, the photosensitive chip 30 can be electrically connected with the electrical holder 10 by fully utilizing the existing technology to reduce the cost of the technical improvement, making full use of the traditional process and equipment to minimize a waste of resources. It is appreciated by one skilled in the art that the electrical connection between the photosensitive chip 30 and the electrical holder 10 can be achieved by any other electronic connection mode, which can accomplish the objects of the present invention. In this aspect, the present invention is not limited. In addition, the photosensitive chip 30 is further connected and coupled on the flexible circuit board 20 such that the photosensitive chip 30 is supported by the flexible circuit board 20.

According to the first preferred embodiment of the present invention, the second indented groove 1120 provides enough space of wire configuration and protection for the lead 60, and the third holder portion 113 ensures the electrical connection of the photosensitive chip 30 and the electrical holder 10 to be more secured.

According to the first preferred embodiment of the present invention, the holder body 11 has a step-stair configuration, which can be used for receiving components, for example, carrying an IRCF or lens thereon.

It is appreciated by one skilled in the art that the structure that the main body 11 comprising the first holder portion 111, the second holder portion 112 and the third holder portion 113 is exemplary only and not intended to be limiting. According to other embodiments of the present invention, the main body 11 may be provided to define a double-step shape, multiple-step shape or non-step shape. In this aspect, the present invention should not be limited. The shape of the main body 11 can be adjusted as required.

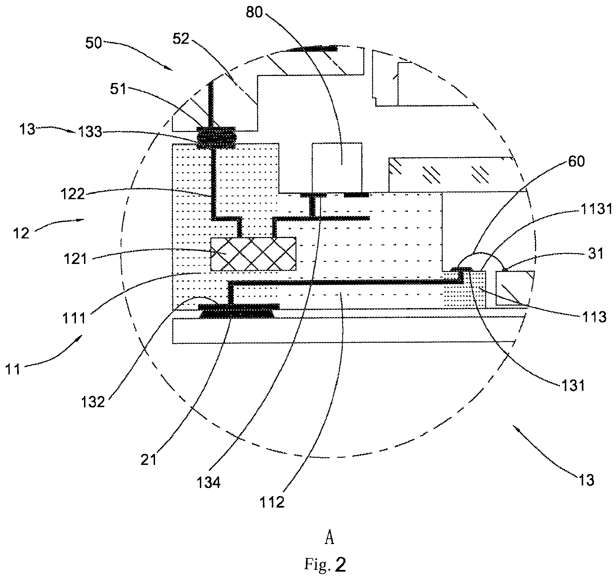

As shown in Figs. 1 and 2, the electrical holder 10 is electrically connected with the flexible circuit board 20. Specifically, the connecting elements 13 of the electronic 10 further comprise a plurality of board connectors 132. The flexible circuit board 20 comprises a plurality of PCB conductive elements 21 and a board body 22, wherein the PCB conductive elements 21 are provided at the board body 22. The PCB conductive elements 21 are electrically connected with the corresponding board connectors 132 so as to electrically connect the flexible circuit board 20 with the electrical holder 10. Therefore, the electrical holder 10 can be electrically connected to a circuit board of an electrical equipment.

According to the first preferred embodiment of the present invention, the electrical holder 10 is coupled to the flexible circuit board 20 to electrically connect the flexible circuit board 20 with the electrical holder 10. It is worth mentioning that the positions of the PCB conductive elements 21 provided on the board body 22 are located corresponding to the location of the board connectors 132 provided on the electrical holder 10, so as to enable the flexible circuit board 20 be electrically connected with the circuit 12. The PCB conductive elements 21 are electrically connected with the board connectors 132 provided on the electrical holder 10, wherein the electric connection may be embodied but not be limited to soldering connection.

According to the first preferred embodiment of the present invention, each of the board connectors 132 can be embodied as but not be limited to a pin or a bonding pad. The electrical holder 10 is electrically connected with the flexible circuit board 20 by soldering. It is appreciated to one skilled in the art that the attaching connection type or welding connection type are exemplary only and not intended to be limiting. The connection between the electrical holder 10 and the flexible circuit board 20 may be embodied as but not be limited to soldering structure.

The connecting elements 13 of the electrical holder 10 further comprise a plurality of driver connectors 133 and a plurality of component connectors 134, wherein the driver connectors 133 are provided on the top surface 1111 of the first holder portion 111. According to the first preferred embodiment of the present invention, each of the driver connectors 133 can be embodied but not be limited to a pin or a bonding pad. The driver bonding pad is used for electrically connecting the driver 50 with the circuit 12 to enable the driver 50 be actuated so as to drive the optical lens 40 such that the camera module is adjusted.

The driver 50 comprises a plurality of driver conductive elements 51 and a driver body 52, wherein the driver conductive elements 51 are provided at the driver body 52. It is worth mentioning that the driver conductive elements 51 are provided on the driver body 52 and are located corresponding to the locations of the driver connectors 133 provided on the electrical holder 10, such that when the driver 50 is coupled at the electrical holder 10, the driver 50 can be electrically connected with the circuit 12 and electrically connected with the flexible circuit board 20. More specifically, the driver conductive elements 51 are electrically connected with the driver connectors 133 of the electrical holder 10, the electrical connection method thereof can be but not be limited to anisotropic conductive paste (ACP), ultrasonic welding, thermal compression welding and reflow soldering.

According to the first preferred embodiment of the present invention, the component connectors 134 are provided on the second top surface 1121 of the second holder portion 112. The component connectors 134 can be embodied as pins or bonding pads, which can be used for electrically connecting the electric components 80. It is appreciated to one skilled in the art that the component connectors 134 is not limited to pins and bonding pads. The electric connection between the electric components 80 and the electrical holder 10 can be embodied but not be limited to welding.

It can be appreciated that, in a further modified embodiment, the electrical holder 10 may also only |embed|[YC1] the electric conductor 122 without embedding the electric element 121, and all the resistors, capacitors and driving elements are mounted on the surface of the holder body 11 in a similar manner to the illustrated electrical element 80.

It is worth mentioning that the flexible circuit board 20 and the electrical holder 10 are two individual components, wherein the configurations of the flexible circuit board 20 and the electrical holder 10 are exemplary only but not to be limiting. According to other embodiments of the present invention, the flexible circuit board 20 may be integrated with the electrical holder 10. In addition, the shapes of the flexible circuit board 20 and the electrical holder 10 can be configured, respectively or integrally, as required.

It is appreciated to one skilled in the art that that the mentioned above connecting elements 13 and the assignment mode thereof are exemplary only but not to be limiting. Any alternative mode accomplishing the object of the present invention should be within the scope of the present invention.

The present invention further provides an assembling method of the camera module. In one embodiment, the camera module is manufactured by coupling the photosensitive chip 30 at the inner side of the electrical holder 10 and locating the optical lens 40 along the photosensitive path of the photosensitive chip 30 that the photosensitive chip 30 is electrically connected with the electrical holder 10. The electrical elements 121 and the electrical conductors 122 are embedded in the main body 11 of the electrical holder 10 to form the circuit 12 embedded therein. The connecting elements 13 are formed on the surface of the main body 11 to facilitate the electrical conduction of the camera module. The main body 11 is formed by arranging a resin or other thermal melting material on a reinforcing steel or copper panel to form the first holder portion 111, the second holder portion 112, the third holder portion 113 and the through hole 100 so as to configure the main body 11 with the step-stair structure. The photosensitive chip 30 is provided in the through hole 100 at the inner side of the electrical holder 10.

The board connectors 132 are provided on the surface of the main body 11, and the flexible circuit board 20 is provided on the electrical holder 10, wherein the flexible circuit board 20 is electrically connected to the circuit 12 via the board connectors 132. The connection method for electrically connecting the flexible circuit board 20 on the electrical holder 10 and for electrically connecting the flexible circuit board 20 with the circuit 12 is selected from the group including welding, anisotropic conductive paste, ultra sonic press, UV exposure, X-ray exposure, conductive glue, hot pressing, and so on.

The driver connectors 133 are formed on the surface of the main body 11 and the optical lens 40 is provided on the driver 50 to form a zoom or auto-focus camera module. The driver 50 is provided on the electrical holder 10 by electrically connecting the driver 50 with the circuit 12 via the driver connectors 133. The connection method for coupling the driver 50 on the electrical holder 10 and for electrically connecting the driver 50 with the circuit 12 is selected from the group including soldering, anisotropic conductive paste, ultra sonic press, UV exposure, X-ray exposure, conductive glue, hot pressing, and so on.

The component connectors 134 are formed on the surface of the main body 11, wherein the electronic components 80 are provided on the main body 11 and are electrically connected with the circuit 12 via the component connectors 134. The connection method for electrically coupling the electronic components 80 on the electrical holder 10 is preferably by a soldering method. Each of the electronic components 80 can be a resistor, a capacitor, a transistor, a converter, diode, a driver chip, and etc.

The photosensitive chip 30 is formed by extending a lead therefrom by the traditional COB, in order to electrically connect with the chip connectors 131 of the electrical holder 10. According to the first preferred embodiment of the present invention, each of the chip connectors 131 can be embodied as but not be limited to a pin or bonding pad. As shown in Figs. 1 to 3, the chip connectors 131 can be provided on the top surface of the third holder portion 113.

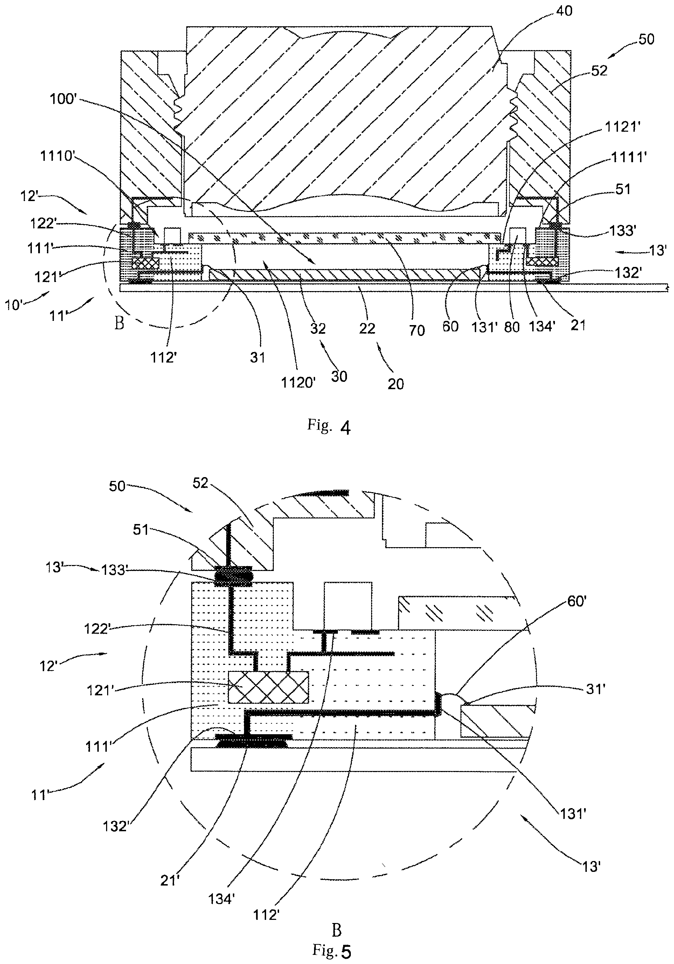

Figs. 4 and 5 illustrate an alternative mode of a camera module according to the first preferred embodiment of the present invention. The camera module comprises an electrical holder 10', a flexible circuit board 20, a photosensitive chip 30, an optical lens 40 and a driver 50.

The optical lens 40 is operatively coupled at the driver 50, and the optical lens 40 can be actuated by the driver 50 to form an auto-focusing or a zoom mechanism. The flexible circuit board 20 and the driver 50 are provided at two different sides of the electrical holder 10' so as to locate the optical lens in the photosensitive path of the photosensitive chip 30. When the camera module is operated for capturing image, the light reflected by the object can be further accepted by the photosensitive chip 30 for photoelectric conversion after passing through the optical lens 40. That is to say, the flexible circuit board 20 and the driver 50 are connected with each other by the electrical holder 10. In other words, the electrical holder 10 serves as an integration of a base and a PCB in a conventional camera module, wherein the electrical holder 10' forms an assembling means for connecting the driver 50 and the optical lens 40 and forms an electrical connection means for electrically connecting to the driver 50, the photosensitive chip 30 and the flexible circuit board 20 with each other.

As shown in Figs. 4 and 5, the electrical holder 10' comprises a main body 11', a circuit 12', a plurality of connecting elements 13' and a through hole 100'. The circuit 12' is embedded in the main body 11', wherein the connecting elements 13' are provided on a surface of the main body 11'. The circuit 12' comprises a plurality of electrical elements 121' and a plurality of electrical conductors 122', wherein the electrical conductors 122' are electrically connected with the electrical elements 121' in a predetermined manner. In addition, the electrical conductors 122' are electrically connected to the driver 50', the flexible circuit board 20' and the photosensitive chip 30' via the connecting elements 13', so as to pre-form a camera circuit of the camera module for activating and adjusting of the camera module.

As shown in Figs. 4 and 5, according to the alternative mode of the first preferred embodiment of the present invention, the main body 11' comprises a first holder portion 111' and a second holder portion 112', wherein the first holder portion 111' forms an outer annular ring body. The second holder portion 112' is integrated with an inner side of the first holder portion 111'. The second supporting portion 112' forms an inner annular ring body. The first holder portion 111' has a first top surface 1111'. The second holder portion 112' has a second top surface 1121'. The second top surface 1121' is inwardly indented with respect to the first top surface 1111' to define a first indented groove 1110'. The main body 11' of the electrical holder 10' of the camera module of the alternative mode according to the first preferred embodiment has a step-stair configuration such that the main body 11' not only provides a securely supporting structure to support to the driver 50 and the optical lens 40 by the first holder portion 111', but also fully utilizes the installation space for other camera components of the camera module. For example, according to the alternative mode of the first preferred embodiment, the camera module further comprises an optical filter 70 and a plurality of electronic components 80, wherein the optical filter 70 is used for filtering useless light to improve the image's quality. The optical filter 70 and the electronic components 80 are provided on the second top surface 1121' of the second holder portion 112' such that the first indented groove 1110' can provide an arrangement space for the optical filter 70 and the electronic components 80.

The photosensitive chip 30 is located corresponding to the through hole 100'. According to the alternative mode of the first preferred embodiment of the present invention, the photosensitive chip 30 is provided in the through hole 100' and is enclosed by the second holder portion 112' to fully utilize the space of the through hole 100'. It is worth mentioning that, in this alternative, the above mentioned third holder portion 113 is omitted in the electrical holder 10'. The photosensitive chip 30 is electrically connected with the inner side of the second holder portion 112'.

The photosensitive chip 30 is electrically connected to the electrical holder 10'. Specifically, the photosensitive chip 30 comprises a plurality of photosensitive chip conductive elements 31 and a chip body 32, wherein the photosensitive chip conductive elements 31 are provided at the chip body 32. The connecting elements 13' of the electronic holder 10' comprises a plurality of chip connectors 131', wherein the photosensitive chip conductive elements 31 are electrically connected with the corresponding chip connectors 131' to achieve the electrical conduction and electrification between the photosensitive chip 30 and the electrical holder 10'. According to the alternative of the first preferred embodiment of the present invention, each of the photosensitive chip conductive elements 31 can be electrically connected with the corresponding chip connector 131' by traditional COB type. In other words, the photosensitive chip 30 is connected with a lead 60 (gold, copper, aluminum and silver wire) by traditional COB type to be electrically connected with the chip connector 131' of the electrical holder 10'. According to the alternative of the first preferred embodiment of the present invention, the chip connector 131' may be embodied as but not be limited to a pin or bonding pad. In other words, the photosensitive chip 30 can be electrically connected with the electrical holder 10' by fully utilizing the existing technology to reduce the cost of the technical improvement, making full use of the traditional process and equipment to minimize the waste of resources. Of course, it is appreciated by one skilled in the art that the electronic connection between the photosensitive chip 30 and the electrical holder 10' can be achieved by any other electronic connection mode, which can accomplish the objects of the present invention. In this aspect, the present invention is not limited.

According to the alternative of the first preferred embodiment of the present invention, the chip connectors 131' are provided at an inner wall of the second holder portion 112'. The through hole 100' provides enough space for wire configuration and protection for the lead 60.

As shown in Figs. 4 and 5, the electrical holder 10' is electrically connected with the flexible circuit board 20. Specifically, the connecting elements 13' of the electrical holder 10' further comprise a plurality of board connectors 132'. The flexible circuit board 20 comprises a plurality of PCB conductive elements 21 and a board body 22, wherein the PCB conductive elements 21 are provided at the board body 22. The PCB conductive elements 21 are electrically connected with the corresponding board connectors 132' to electrically connect the flexible circuit board 20 with the electrical holder 10', such that the electrical holder 10' can be electrically connected to a power unit.

According to the alternative of the first preferred embodiment of the present invention, the electrical holder 10' is electrically connected with the flexible circuit board 20 to ensure the flexible circuit board 20 to be securely supported and electrically connected with the electrical holder 10'. It is worth mentioning that the PCB conductive elements 21 are provided on the board body 22 and are located corresponding to the location of the board connectors 132' provided on the electrical holder 10' so as to enable the flexible circuit board 20 to be electrically connected with the circuit 12'. The PCB conductive elements 21 are electrically connected with the board connectors 132' provided on the electrical holder 10', wherein the electrical connection may be embodied but not be limited to soldering connection.

According to the alternative of the first preferred embodiment of the present invention, each of the board connectors 132' can be embodied as but not be limited to a pin or bonding pad. The electrical holder 10' is electrically connected with the flexible circuit board 20 by soldering. It is appreciated to one skilled in the art that the attaching connection type or soldering connection type are exemplary only and not intended to be limiting. The connection between the electrical holder 10' and the flexible circuit board 20 may be embodied as but not be limited to soldering structure.

The connecting elements 13' of the electrical holder 10' further comprise a plurality of driver connectors 133' and a plurality of component connectors 134', wherein the driver connectors 133' are provided on the top surface 1111' of the first holder portion 111'. According to the alternative of the first preferred embodiment of the present invention, each of the driver connectors 133' can be embodied but not be limited to a pin or bonding pad. The driver bonding pad is used for electrically connecting the driver 50 with the circuit 12' to enable the driver 50 be actuated so as to drive the optical lens 40 such that the camera module is adjusted.

The driver 50 comprises a plurality of driver conductive elements 51 and a driver body 52, wherein the driver conductive elements 51 are provided at the driver body 52. It is worth mentioning that the driver conductive elements 51 are provided on the driver body 52 and are located corresponding to the locations of the driver connectors 133' provided on the electrical holder 10' such that when the driver 50 is provided at the electrical holder 10', the driver 50 can be electrically connected with the circuit 12' and electrically connected with the flexible circuit board 20. More specifically, the driver conductive elements 51 are electrically connected with the driver connectors 133' of the electrical holder 10', the electrical connection method thereof can be but not be limited to anisotropic conductive paste (ACP), ultrasonic welding, thermal compression welding and reflow soldering.

According to the alternative of the first preferred embodiment of the present invention, the component connectors 134' are provided on the second top surface 1121' of the second holder portion 112'. The component connectors 134' can be embodied as pins or bonding pads, which can be used for electrically connecting the electric components 80. It is appreciated to one skilled in the art that the electric connection between the electric components 80 and the electrical holder 10' can be embodied but not be limited to soldering method.

The camera module according to the alternative of the first preferred embodiment is manufactured by coupling the photosensitive chip 30 at an inner side of the electrical holder 10', locating the optical lens 40 along the photosensitive path of the photosensitive chip 30, electrically connecting the photosensitive chip 30 with the electrical holder 10', embedding a plurality of electrical elements 121' and a plurality of electrical conductors 122' in the main body 11' of the electrical holder 10' to form the circuit 12' embedded in the main body 11', and providing the connecting elements 13' on the surface of the main body 11' to facilitate the electric conduction of the camera module. The main body 11' is formed by arranging a resin on a reinforcing steel or copper panel to form the first holder portion 111', the second holder portion 112' and the through hole 100' so as to configure the main body 11' with the step-stair structure. The photosensitive chip 30 is provided in the through hole 100' in the inner side of the second holder portion 112'.

The board connectors 132' are provided on the surface of the main body 11', and the flexible circuit board 20 is provided on the electrical holder 10', wherein the circuit 12' is connected electrically with the flexible circuit board 20 via the board connectors 132'. The connection method for electrically connecting the flexible circuit board 20 on the electrical holder 10' and for electrically connecting the flexible circuit board 20 with the circuit 12' is selected from the group consisting of soldering, anisotropic conductive paste, ultra sonic press, UV exposure, X-ray exposure, conductive glue, hot pressing, and etc.

The driver connectors 133' are provided on the surface of the main body 11' and the optical lens 40 is provided on the driver 50 to form a zoom or auto-focus camera module. The driver 50 is provided on the electrical holder 10' by electrically connecting the circuit 12' with the driver 50 via the driver connectors 133'. The connection method for electrically coupling the driver 50 on the electrical holder 10' and for electrically connecting the driver 50 with the circuit 12' is selected from the group consisting of soldering, anisotropic conductive paste, ultra sonic press, UV exposure, X-ray exposure, conductive glue, hot pressing, and etc.

The component connectors 134' are provided on the surface of the main body 11', wherein the electronic components 80 are provided on the main body 11' and are electrically connected with the circuit 12' via the component connectors 134'. The connection method for electrically coupling the electronic components 80 on the electrical holder 10' is preferably by a soldering method.

The photosensitive chip 30 is formed by extending a lead therefrom by the traditional COB, in order to electrically connect with the chip connectors 131' of the electrical holder 10'. Each of the chip connectors 131' can be embodied as but not be limited to a pin or bonding pad. As shown in Figs. 4 to 5, the chip connectors 131' can be provided on the inner surface of the second holder portion 112'.

It is worth mentioning that the electrical holder of the present invention can be used for zoom camera modules, auto-focus camera modules or fixed-focus camera modules.

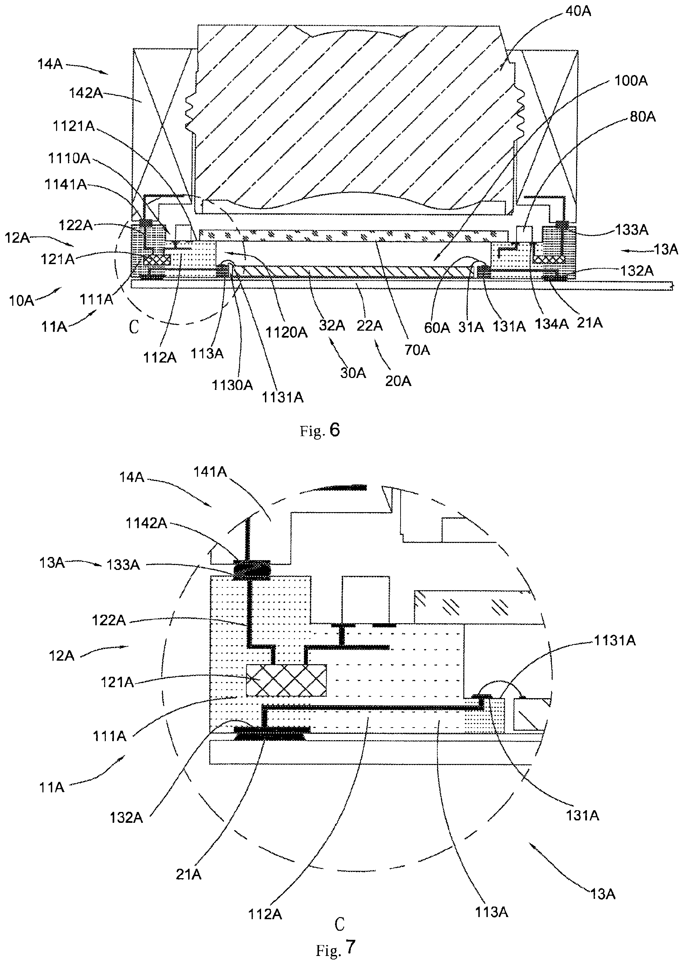

As shown in Fig. 6 and 7, a camera module according to a second preferred embodiment of the present invention illustrates another alternative mode of the first embodiment. The camera module comprises an electrical holder 10A, a flexible circuit board 20A, a photosensitive chip 30A, an optical lens 40 A. In the second embodiment, the camera module is a fixed-focus camera module that the above mentioned driver is omitted.

The electrical holder 10A comprises a main body 11A, a circuit 12A, a plurality of connecting elements 13A, and a through hole 100A. The circuit 12A comprises a plurality of electrical elements 121A and a plurality of electrical conductors 122A, wherein the electrical conductors 122A are electrically connected with the electrical elements 121A in a predetermined manner. In addition, the electrical conductors 122A are electrically connected to the flexible circuit board 20A and the photosensitive chip 30A via the connecting elements 13A, so as to pre-form a camera circuit of the camera module.

The optical lens 40A and the photosensitive chip 30A are provided at two different sides of the electrical holder 10A so as to locate the optical lens 40A along a photosensitive path of the photosensitive chip 30. When the camera module is operated for capturing image, the light reflected by the object can be further accepted by the photosensitive chip 30A for photoelectric conversion after passing through the optical lens 40A. That is to say, the flexible circuit board 20A is connected with the electrical holder 10A. In other words, the electrical holder 10A serves as an integration of a base and a PCB in a conventional camera module, wherein the electrical holder 10A forms an assembling means for connecting the optical lens 40A and forms an electrical connection means for electrically connecting to the photosensitive chip 30A and the flexible circuit board 20A with each other.

As shown in Figs. 6 and 7, according to the second preferred embodiment of the present invention, the main body 11A comprises a first holder portion 111A, a second holder portion 112A and a third holder portion 113A. It is worth mentioning that the first holder portion 111A, the second holder portion 112A and the third holder portion 113A are integrated with each other. The electrical holder further comprises a lens holder 14A. The lens holder 14A can be integrated with the first holder portion 111A, the second holder portion 112A or the third holder portion 113A. Alternatively, the lens holder 14A can be detachably connected with the first holder portion 111A, the second holder portion 112A or the third holder portion 113A. According to the second preferred embodiment of the present invention, which is illustrated in Figs. 6 and 7, the lens holder 14A is integrated with the first holder portion 111A. In this aspect, the present invention is not limited.

According to the second embodiment of the present invention, the first holder portion 111A forms an outer annular ring body. The second holder portion 112A is integrated with an inner side of the first holder portion 111A, and the third holder portion 113A is integrated with an inner side of the second holder portion 112A. Therefore, the second holder portion 112A forms a middle annular ring body. The third holder portion 113A forms an inner annular ring body. The first holder portion 111A has a first top surface 1111A. The second holder portion 112A has a second top surface 1121A. The third holder portion 113A has a third top surface 1121A. The second top surface 1121A is inwardly indented with respect to the first top surface 1111A to define a first indented groove 1110A, and the third holder portion 113A has a third indented groove 1130A at an inner side thereof. The main body 11A of the electrical holder 10A of the camera module according to the second preferred embodiment has a step-stair configuration such that the main body 11A not only provides a securely supporting structure to support to the lens holder 14A and the optical lens 40A by the first holder portion 111A, but also fully utilizes the installation space for other camera components of the camera module. For example, according to the second embodiment of the present invention, the camera module further comprises an optical filter 70A and a plurality of electronic components 80A, wherein the optical filter 70A is used for filtering useless light to improve the image's quality. The optical filter 70A and the electronic components 80A are provided on the second top surface 1121A of the second holder portion 112A, such that the first indented groove 1110A can provide an arrangement space for the optical filter 70A and the electronic components 80A.

The photosensitive chip 30A is located corresponding to the through hole 100A. According to the second embodiment of the present invention, the photosensitive chip 30A is provided in the through hole 100A and is enclosed by the third holder portion 113A to fully utilize the space of the through hole 100A. It is worth mentioning that the setting location of the photosensitive chip 30A is exemplary only and not intended to be limiting. According to other embodiments of the present invention, the photosensitive chip 30A may be provided at other positions, for example, a top side of the third top surface 1131A of the third holder portion 113A.

The photosensitive chip 30A is electrically connected to the electrical holder 10A. Specifically, the photosensitive chip 30A comprises a plurality of photosensitive chip conductive elements 31A and a chip body 32A, wherein the photosensitive chip conductive elements 31A are provided at the chip body 32A. The connecting elements 13A of the electrical holder 10A comprises a plurality of chip connectors 131A, wherein the photosensitive chip conductive elements 31A are electrically connected with the corresponding chip connectors 131A to achieve the electrical conduction and electrification between the photosensitive chip 30A and the electrical holder 10A. According to the second embodiment of the present invention, each of the photosensitive chip conductive elements 31A can be electrically connected with the corresponding chip connector 131A by the traditional COB type. In other words, the photosensitive chip 30A is connected with a lead 60A (gold, copper, aluminum and silver wire) by the traditional COB type for electrically connecting with the chip connector 131A of the electrical holder 10A. According to the second embodiment of the present invention, the chip connector 131A may be embodied as but not be limited to a pin or bonding pad. In other words, the photosensitive chip 30A can be electrically connected with the electrical holder 10A by fully utilizing the existing technology to reduce the cost of the technical improvement, making full use of the traditional process and equipment to minimize the waste of resources. Of course, it is appreciated by one skilled in the art that the electrical connection between the photosensitive chip 30A and the electrical holder 10A can be achieved by any other electronic connection mode, which can accomplish the objects of the present invention. In this aspect, the present invention is not limited.

According to the second embodiment of the present invention, the second indented groove 1120A provides enough space of wire configuration and protection for the lead 60 and the third holder portion 113A ensures the electrical connection of the photosensitive chip 30A and the electrical holder 10A to be more secured.

It is appreciated by one skilled in the art that the structure that the main body 11A comprises the first holder portion 111A, the second holder portion 112A and the third holder portion 113A is exemplary only and not intended to be limiting. According to other embodiments of the present invention, the main body 11A may be provided to define a double-step shape, multiple-step shape or non-step shape. In this aspect, the present invention should not be limited. During the process that the camera module is designed, the shape of the main body 11A can be adjusted corresponding to the required.

As shown in Figs. 6 and 7, the electrical holder 10A is electrically connected with the flexible circuit board 20A. Specifically, the connecting elements 13A of the electronic 10A further comprise a plurality of board connectors 132A. The flexible circuit board 20A comprises a plurality of PCB conductive elements 21A and a board body 22A, wherein the PCB conductive elements 21A are provided at the board body 22A. The PCB conductive elements 21A are electrically connected with the corresponding board connectors 132A so as to electrically connect the electrical holder 10A with the flexible circuit board 20A. Therefore, the electrical holder 10A can be electrically connected to a power unit.

According to the second embodiment of the present invention, the electrical holder 10A is coupled to the flexible circuit board 20A to electrically connect the electrical holder 10A with the flexible circuit board 20A. It is worth mentioning that the PCB conductive elements 21A are provided on the board body 22A and located corresponding to the locations of the board connectors 132A provided on the electrical holder 10A so as to enable the flexible circuit board 20A be electrically connected with the circuit 12A. The PCB conductive elements 21A are electrically connected with the board connectors 132A provided on the electrical holder 10A, wherein the electric connection may be embodied but not be limited to soldering connection.

According to the second embodiment of the present invention, each of the board connectors 132A can be embodied as but not be limited to a pin or bonding pad. The electrical holder 10A is electrically connected with the flexible circuit board 20A by soldering. It is appreciated to one skilled in the art that the attaching connection type or soldering connection type are exemplary only and not intended to be limiting. The connection between the electrical holder 10' and the flexible circuit board 20 may be embodied as but not be limited to soldering.

The connecting elements 13A of the electrical holder 10A further comprise a plurality of component connectors 134A and a plurality of connecting members 133A, wherein the connecting members 133A are provided on the top surface 1111A of the first holder portion 111A. According to the second embodiment of the present invention, each of the connecting members 133A can be embodied but not be limited to a pin or bonding pad. It is worth mentioning that not only the first holder portion 111A, the second holder portion 112A and the third holder portion 113A of the main body 11A, but also the lens holder 14A can be used for an embedded circuit to further improve available space of necessary components so as to minimize the size of the entire camera module. It is appreciated that the lens holder 14A can also be used in the embedded circuit. A bonding pad of the lens holder 14A is used for connecting the embedded circuit with the embedded circuits of the first holder portion 111A, the second holder portion 112A and the third holder portion 113A so as to form the circuit 12A. It is appreciated by one skilled in the art that, in some embodiments that the lens holder 14A is integrated with the first holder portion 111A, the second holder portion 112A or the third holder portion 113A, wherein the connecting members 133A are omitted.

According to the second embodiment of the present invention, the lens holder 14A comprises a plurality of holder circuit connectors 141A and a holder body 142A, wherein the holder circuit connectors 141A are provided at the holder body 142A. It is worth mentioning that the holder circuit connectors 141A are provided on the holder body 142A and are located corresponding to the location of the connecting members 133A provided on the electrical holder 10A such that when the lens holder 14A is coupled at the electrical holder 10A, the lens holder 14A can be electrically connected with the circuit 12A and electrically connected with the flexible circuit board 20A. More specifically, the holder circuit connectors 141A are electrically connected with the connecting members 133A of the electrical holder 10A, wherein the electrical connection method can be but not be limited to anisotropic conductive paste (ACP), ultrasonic welding, thermal compression welding and reflow soldering.

According to the second embodiment of the present invention, the component connectors 134A are provided on the second top surface 1121A of the second holder portion 112A. The component connectors 134A can be embodied as pins or bonding pads, which can be used for electrically connecting the electric components 80A. It is appreciated to one skilled in the art that the electrical connection between the electric components 80A and the electrical holder 10A can be embodied but not be limited to welding.

It is worth mentioning that the flexible circuit board 20A and the electrical holder 10A are two individual components, wherein the configurations of the flexible circuit board 20A and the electrical holder 10A are exemplary only but not to be limiting. According to other embodiments of the present invention, the flexible circuit board 20A may be integrated with the electrical holder 10A. In addition, the shapes of the flexible circuit board 20A and the electrical holder 10A can be configured, respectively or integrally, as required.

The camera module according to the second embodiment is manufactured by coupling the photosensitive chip 30A at an inner side of the electrical holder 10A, locating the optical lens 40A along the photosensitive path of the photosensitive chip 30A, electrically connecting the photosensitive chip 30A with the electrical holder 10A, embedding a plurality of electrical elements 121A and a plurality of electrical conductors 122A in the main body 11A of the electrical holder 10A to form the circuit 12A embedded in the main body 11A and the lens holder 14A, and arranging the connecting elements 13A on the surface of the main body 11A to facilitate the electric conduction of the camera module. The main body 11A is formed by arranging a laminate resin on a reinforcing steel or copper panel to form the first holder portion 111A, the second holder portion 112A, the third holder portion 113A and the through hole 100A so as to configure the main body 11A with the step-stair structure. The photosensitive chip 30A is provided in the through hole 100A.

The board connectors 132A is provided on the surface of the main body 11A, and the flexible circuit board 20A is provided on the electrical holder 10A, wherein the circuit 12A is connected electrically with the flexible circuit board 20A via the board connectors 132A. The connection method for electrically connecting the flexible circuit board 20A on the electrical holder 10A and for electrically connecting the flexible circuit board 20A with the circuit 12A is selected from the group consisting of soldering, anisotropic conductive paste and hot pressing.

The connecting members 135A are provided on a surface of the main body 11A. The optical lens 40A is provided at the lens holder 14A to form a fixed-focus camera module. The lens holder 14A is provided at the main body 11A and electrically connected with the electrical elements 121A and the electrical conductors 122A embedded in the main body 11A by the connecting members 135A. The connection method for coupling the lens holder 14A at the main body 11A and electrically connecting the electrical elements 121A and the electrical conductors 122A embedded in the main body 11A with the circuit 12A embedded in the lens holder 14A is selected from the group including soldering, anisotropic conductive paste, ultra sonic press, UV exposure, X-ray exposure, conductive glue, hot pressing, and etc.

The component connectors 134A are provided on the surface of the main body 11A and the electronic components 80A are provided on the main body 11A, wherein the electronic components 80A are electrically connected with the circuit 12A by the component connectors 134A. The connection method for electrically coupling the electronic components 80A on the electrical holder 10A is preferably by a soldering method. The electronic components 80A comprise a plurality of resistances, capacitances, transistor, converter, diode, or driver chips.

The photosensitive chip 30A is formed by extending a lead therefrom by traditional COB to electrically connect with the chip connectors 131A of the electrical holder 10A. Each of the chip connectors 131A can be embodied as but not be limited to a pin or bonding pad.

It is appreciated to one skilled in the art that the above connecting elements 13A and the configuration mode thereof is exemplary only but not intend to be limiting. Any alternative mode accomplishing the object of the present invention should be within the scope of the present invention.

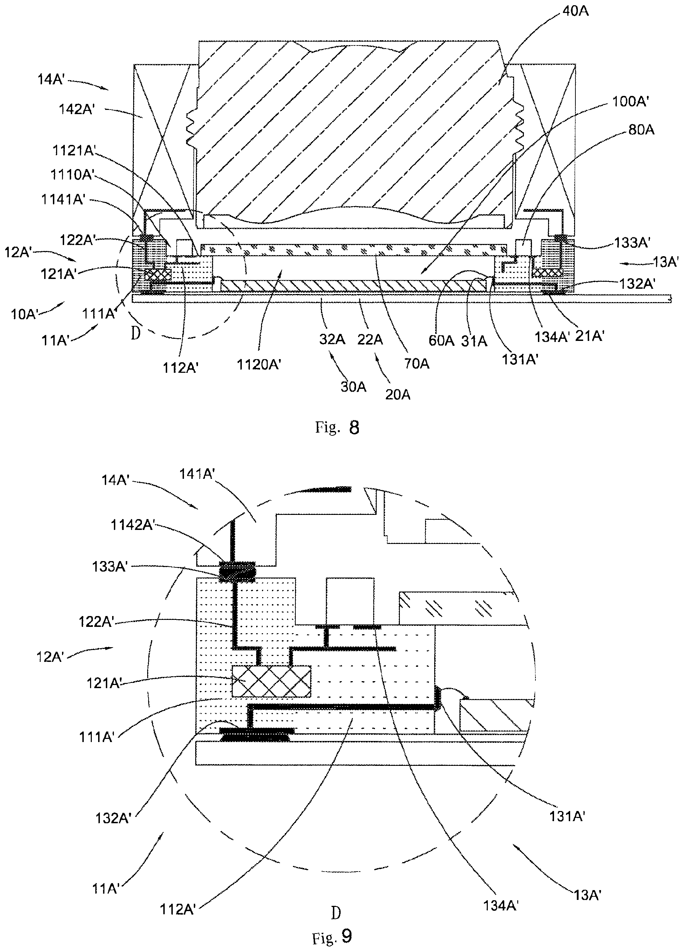

Figs. 8 and 9 illustrate an alternative mode of a camera module according to the second preferred embodiment of the present invention. The camera module comprises an electrical holder 10A', a flexible circuit board 20A, a photosensitive chip 30A, and an optical lens 40A.

The electrical holder 10A' comprises a main body 11A', a circuit 12A', a plurality of connecting elements 13A', and a through hole 100A'. The circuit 12A' comprises a plurality of electrical elements 121A' and a plurality of electrical conductors 122A', wherein the electrical conductors 122A' are electrically connected with the electrical elements 121A' in a predetermined manner. In addition, the electrical conductors 122A' are electrically connected to the flexible circuit board 20A' and the photosensitive chip 30A' via the connecting elements 13A', so as to pre-form a camera circuit of the camera module.

The optical lens 40A and the photosensitive chip 30A are provided at two different sides of the electrical holder 10A' to locate the optical lens 40A along the photosensitive path of the photosensitive chip 30A. When the camera module is operated for capturing image, the light reflected by the object can be further accepted by the photosensitive chip 30A for photoelectric conversion after passing through the optical lens 40A. That is to say, the flexible circuit board 20A is connected with the electrical holder 10A'. In other words, the electrical holder 10A' serves as an integration of a base and a PCB in a conventional camera module, wherein the electrical holder 10A' forms an assembling means for connecting the optical lens 40A and forms an electrical connection means for electrically connecting the photosensitive chip 20A and the flexible circuit board 20A with each other.

As shown in Figs. 8 and 9, according to the alternative mode of the second embodiment of the present invention, the main body 11A' comprises a first holder portion 111A' and a second holder portion 112A'. It is worth mentioning that the first holder portion 111A' and the second holder portion 112A' are integrated with each other. The electrical holder 10A' further comprises a lens holder 14A'. The lens holder 14A' may be integrated with the first holder portion 111A' or the second holder portion 112A'. Alternatively, the lens holder 14A' can be detachably connected with the first holder portion 111A' or the second holder portion 112A'. According to the alternative mode of the second preferred embodiment of the present invention, which is illustrated in Figs. 8 and 9, the lens holder 14A' is integrated with the first holder portion 111A'. In this aspect, the present invention is not limited.

According to the alternative mode of the second embodiment of the present invention, the first holder portion 111A' forms an outer annular ring body. The second holder portion 112A' is integrated with an inner side of the first holder portion 111A. The second holder portion 112A' forms an inner annular ring body. The first holder portion 111A' has a first top surface 1111A'. The second holder portion 112A' has a second top surface 1121A'. The second top surface 1121A' is inwardly indented with respect to the first top surface 1111A' to form a first indented groove 1110A' at an inner side of the first holder portion 111A' and a bottom side of the second holder portion 112A', and to form a second indented groove 1120A' at an inner side of the second holder portion 112A', wherein the first indented groove 1110A' and the second indented groove 1120A' form the through hole 100A'. The main body 11A' of the electrical holder 10A' of the camera module according to the alternative mode of the second preferred embodiment has a step-stair configuration such that the main body 11A' not only securely supporting structure to support the lens holder 14A' and the optical lens 40' by the first holder portion 111A', but also fully utilizes the installation space for other camera components of the camera module. For example, according to the alternative of the second embodiment of the present invention, the camera module further comprises an optical filter 70A and a plurality of electronic components 80A, wherein the optical filter 70A is used for filtering useless light to improve the image's quality. The optical filter 70A and the electronic components 80A are provided on the second top surface 1121A' of the second holder portion 112A' such that the first indented groove 1110A' can provide an arrangement space for the optical filter 70A and the electronic components 80A.

The photosensitive chip 30A is located corresponding to the through hole 100A. According to the alternative mode of the second embodiment of the present invention, the photosensitive chip 30A is provided in the through hole 100A' and is enclosed by the second holder portion 112A' so as to fully utilize the space of the through hole 100A'.

The photosensitive chip 30A is electrically connected to the electrical holder 10A'. Specifically, the photosensitive chip 30A comprises a plurality of photosensitive chip conductive elements 31A and a chip body 32A, wherein the photosensitive chip conductive elements 31A are provided at the chip body 32A. The connecting elements 13A' of the electrical holder 10A' comprises a plurality of chip connectors 131A', wherein the photosensitive chip conductive elements 31A are electrically connected with the corresponding chip connectors 131A' to achieve the electrical conduction and electrification of the photosensitive chip 30A and the electrical holder 10A'. According to the alternative mode of the second embodiment of the present invention, each of the photosensitive chip conductive elements 31A can be electrically connected with the corresponding chip connector 131A' by the traditional COB type. In other words, the photosensitive chip 30A is connected with a lead 60A (gold, copper, aluminum and silver wire) by the traditional COB type to be connected electrically with the chip connector 131A' of the electrical holder 10A'. According to the alternative mode of the second embodiment of the present invention, the chip connector 131A' may be embodied as but not be limited to a pin or bonding pad. In other words, the photosensitive chip 30A can be electrically connected with the electrical holder 10A' by fully utilizing the existing technology to reduce the cost of the technical improvement, making full use of the traditional process and equipment to minimize a waste of resources. Of course, it is appreciated by one skilled in the art that the electronic connection between the photosensitive chip 30A and the electrical holder 10A' can be achieved by any other electronic connection mode, which can accomplish the objects of the present invention. In this aspect, the present invention is not limited.

According to the alternative mode of the second embodiment of the present invention, the photosensitive chip connector 131A' is provided at an inner wall of the second holder portion 1120A'. The through hole 100' provides enough space of wire configuration and protection for the lead60A.

As shown in Figs. 8 and 9, the electrical holder 10A' is electrically connected with the flexible circuit board 20A. Specifically, the connecting elements 13A' of the electrical holder 10A' further comprise a plurality of board connectors 132A'. The flexible circuit board 20A comprises a plurality of PCB conductive elements 21A' and a board body 22A, wherein the PCB conductive elements 21A' are provided at the board body 22A. The PCB conductive elements 21A' are electrically connected with the corresponding board connectors 132A' to electrically connect the electrical holder 10A' with the flexible circuit board 20A, such that the electrical holder 10A' can be electrically connected to a power unit.

According to the alternative mode of the second embodiment of the present invention, the electrical holder 10A' is electrically connected with the flexible circuit board 20A to ensure the flexible circuit board 20A to be securely supported and electrically connected with the electrical holder 10A'. It is worth mentioning that the PCB conductive elements 21A' are provided on the board body 22A and are located corresponding to the locations of the board connectors 132A' provided on the electrical holder 10A' so as to enable the flexible circuit board 20A to be electrically connected with the circuit 12A'. The PCB conductive elements 21A' are electrically connected with the board connectors 132A' provided on the electrical holder 10A', wherein the electrical connection may be embodied but not be limited to soldering connection.

According to the alternative mode of the second embodiment of the present invention, each of the board connectors 132A' can be embodied as but not be limited to a pin or bonding pad. The electrical holder 10A' is electrically connected with the flexible circuit board 20A by soldering. It is appreciated to one skilled in the art that the attaching connection type or soldering connection type are exemplary only and not intended to be limited in the present invention. The connection between the electrical holder 10' and the flexible circuit board 20 may be embodied as but not be limited to soldering structure.

The connecting elements 13A' of the electrical holder 10A' further comprise a plurality of component connectors 134A' and a plurality of connecting members 133A', wherein the connecting members 133A' are provided on the top surface 1111A' of the first holder portion 111A'. According to the alternative mode of the second embodiment of the present invention, each of the connecting members 133A' can be embodied but not be limited to a pin or bonding pad. It is worth mentioning that not only the first holder portion 111A' and the second holder portion 112A of the main body 11A', but also the lens holder 14A' can be used for an embedded circuit to further improve available space of necessary components so as to minimize the size of the entire camera module. Of course, the lens holder 14A' can also be used in the embedded circuit. A bonding pad of the lens holder 14A' is used for connecting the embedded circuit with the embedded circuits of the first holder portion 111A' and the second holder portion 112A' so as to form the circuit 12A'. It is appreciated by one skilled in the art that, in some embodiments that the lens holder 14A' is integrated with the first holder portion 111A' or the second holder portion 112A', wherein the connecting members 133A' are omitted.

According to the alternative mode of the second embodiment of the present invention, the lens holder 14A' comprises a plurality of holder circuit connectors 1141A' and a holder body 142A', wherein the holder circuit connectors 1141A' are provided at the holder body 142A'. It is worth mentioning that the holder circuit connectors 1141A' are provided on the holder body 142A' and are located corresponding to the locations of the connecting members 133A' provided on the electrical holder 10A' such that when the lens holder 14A' is provided at the electrical holder 10A', the lens holder 14A' can be electrically connected with the circuit 12A' and electrically connected with the flexible circuit board 20A. More specifically, the holder circuit connectors 1141A' are electrically connected with the connecting members 133A' of the electrical holder 10A', wherein the electric connection method can be, but not be limited to, anisotropic conductive paste (ACP), ultrasonic welding, thermal compression welding and reflow soldering.

According to the alternative mode of the second embodiment of the present invention, the component connectors 134A' are provided on the second top surface 1121A' of the second holder portion 112A'. The component connectors 134A' can be embodied as pins or bonding pads, which can be used for electrically connecting the electric components 80A. It is appreciated to one skilled in the art that the electric connection between the electric components 80A and the electrical holder 10A' can be embodied, but not be limited, to soldering method.

The camera module according to the alternative mode of second embodiment is manufactured by coupling the photosensitive chip 30A at an inner side of the electrical holder 10A', locating the optical lens 40A along the photosensitive path of the photosensitive chip 30A, electrically connecting the photosensitive chip 30A with the electrical holder 10A', embedding a plurality of electrical elements 121A' and a plurality of electrical conductors 122A' in the main body 11A' of the electrical holder 10A' to form the circuit 12A' embedded in the main body 11A' and the lens holder 14A', and arranging the connecting elements 13A' on the surface of the main body 11A' to facilitate the electric conduction of the camera module. The main body 11A' is formed by arranging resin on a reinforcing steel or copper panel to form the first holder portion 111A', the second holder portion 112A' and the through hole 100A' so as to configure the main body 11A' with the step-stair structure. The photosensitive chip 30A is provided in the through hole 100A' and is electrically connected at an inner side of the second holder portion 112A'.

The board connectors 132A' are provided on the surface of the main body 11A', and the flexible circuit board 20A is provided on the electrical holder 10A', wherein the circuit 12A' is electrically connected with the flexible circuit board 20A by the board connectors 132A'. The connection method for electrically connecting the flexible circuit board 20A on the electrical holder 10A' and for electrically connecting the flexible circuit board 20A be connected with the circuit 12A' is selected from the group including soldering, anisotropic conductive paste, ultra sonic press, UV exposure, X-ray exposure, conductive glue, hot pressing, and etc.

The connecting members 135A' are provided on a surface of the main body 11A'. The optical lens 40A is provided at the lens holder 14A' to form a fixed-focus camera module. The lens holder 14A' is provided at the main body 11A' and electrically connected with the electrical elements 121A' and the electrical conductors 122A' embedded in the main body 11A' by the connecting members 133A'. The connection method for coupling the lens holder 14A' at the main body 11A' and electrically connecting the electrical elements 121A' and the electrical conductors 122A' embedded in the main body 11A' with the circuit 12A' embedded in the lens holder 14A' is selected from a group including soldering, anisotropic conductive paste, ultra sonic press, UV exposure, X-ray exposure, conductive glue, hot pressing, and etc.

The component connectors 134A' are provided on the surface of the main body 11A' and the electronic components 80A are provided on the main body 11A', wherein the electronic components 80A are electrically connected with the circuit 12A' by the component connectors 134A'. The connection method for electrically coupling the electronic components 80A on the electrical holder 10A' is preferably, but not limited, by a soldering method.

The photosensitive chip 30A is formed by extending a lead therefrom by the traditional COB type, in order to electrically connect with the chip connectors 131A' of the electrical holder 10A'. Each of the chip connectors 131A' can be embodied as but not be limited to a pin or bonding pad.

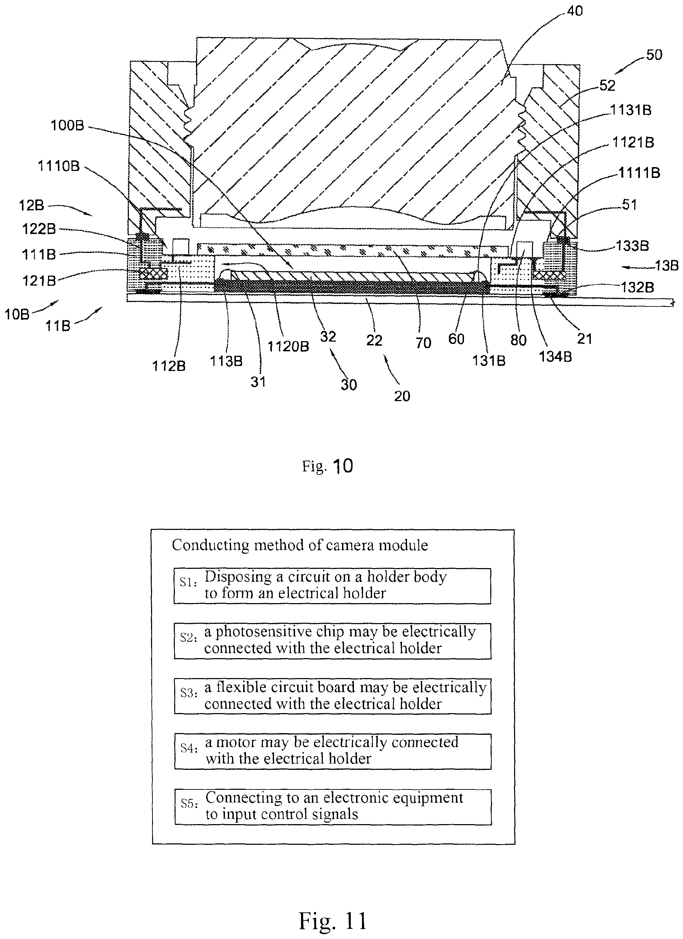

Fig. 10 illustrates a camera module according to a third preferred embodiment of the present invention, wherein the camera module of the third preferred embodiment has the same structural configuration as the camera module of the first preferred embodiment, except the electrical holder 10B. As shown in Fig. 10, the electrical holder 10B comprises a main body 11B, a circuit 12B, and a plurality of connecting elements 13B. The difference between the electrical holder 10B of the third embodiment and the electrical holder 10 of the first embodiment is that there is no through hole formed at the electrical holder 10B of the third embodiment. In other words, the electrical holder of the present invention can be configured to have no through hole penetrating through the electrical holder. The circuit 12B comprises a plurality of electrical elements 121B and a plurality of electrical conductors 122B, wherein the electrical conductors 122B are electrically connected with the electrical elements 121B in a predetermined manner. In addition, the electrical conductors 122B are electrically connected to the flexible circuit board 20 and the photosensitive chip 30 via the connecting elements 13B, so as to pre-form a camera circuit of the camera module.

As shown in Fig. 10, according to the third embodiment of the present invention, the main body 11B comprises a first holder portion 111B, a second holder portion 112B and a third holder portion 113B. It is worth mentioning that the first holder portion 111B, the second holder portion 112B and the third holder portion 113B are integrated with each other.

According to the third embodiment of the present invention, the first holder portion 111B forms an outer annular ring body. The second holder portion 112B is integrated with an inner side of the first holder portion 111B, wherein the third holder portion 113B is integrated with an inner side of the second holder portion 112B such that the second holder portion 112B forms a middle annular ring body. The third holder portion 113B forms a base. The first holder portion 111B has a first top surface 1111B. The second holder portion 112B has a second top surface 1121B. The third holder portion 113B has a third top surface 1131B. The second top surface 1121B is inwardly indented with respect to the first top surface 1111B to define a first indented groove 1110B. The third top surface 1131B is inwardly indented with respect to the second top surface 1121B to define a second indented groove 1120B provided on the inner side of the second holder portion 112, wherein the first indented groove 1110B and the second indented groove 1120B to form an integrated groove 100B, and the integrated groove 100B does not penetrate through the electrical holder 10B. The bottom side of the third holder portion 113B seals the integrated groove 100B and forms a bottom side thereof. The main body 11B of the electrical holder 10B of the camera module according to the third embodiment has a step-stair configuration such that the main body 11B not only provides a securely supporting structure to support the driver 50 and the optical lens 40 by the first holder portion 111B, but also fully utilizes the installation space for other camera components of the camera module. For example, according to the third embodiment, the camera module further comprises an optical filter 70 and a plurality of electronic components 80, wherein the optical filter 70 is used for filtering useless light to improve the image's quality. The optical filter 70 and the electronic components 80 are provided on the second top surface 1121B of the second holder portion 112B such that the first concave groove 1110B can supply arrangement space for the optical filter 70 and the electronic components 80.

As shown in Fig. 10, the photosensitive chip 30 is provided on a top surface of the third holder portion 113B. The photosensitive chip 30 is electrically connected to the circuit 12B of the electrical holder 10B. Specifically, the photosensitive chip 30 comprises a plurality of photosensitive chip conductive elements 31 and a chip body 32, wherein the photosensitive chip conductive elements 31 are provided at the chip body 32. The connecting elements 13B of the electronic 10B comprises a plurality of chip connectors 131B, wherein the photosensitive chip conductive elements 31 are electrically connected with the corresponding chip connectors 131B to achieve the electrical conduction and electrification of the photosensitive chip 30 and the electrical holder 10B. According to the third preferred embodiment of the present invention, each of the photosensitive chip conductive elements 31 can be electrically connected with the corresponding chip connector 131B by traditional COB type. In other words, the photosensitive chip 30 is connected with a lead60 (gold, copper, aluminum and silver wire) by traditional COB type to be electrically connected with the chip connector 131B of the electrical holder 10B. According to the third embodiment of the present invention, each of the chip connectors 131B may be embodied as but not be limited to a pin or bonding pad. The second indented groove 1120B provides enough space for wire configuration and protection for the lead 60, and the third holder portion 113B ensures the electrical connection of the photosensitive chip 30 and the electrical holder 10B to be more secured. It is appreciated that the photosensitive chip connector 131B can be provided on the top surface of the third holder portion 113B and can also be provided on an inner surface of the second holder portion 112B.

As shown in Fig. 10, the electrical holder 10B is electrically connected with the flexible circuit board 20. Specifically, the connecting elements 13B of the electrical holder 10B further comprise a plurality of board connectors 132B. The flexible circuit board 20 comprises a plurality of PCB conductive elements 21 and a board body 22, wherein the PCB conductive elements 21 are provided at the board body 22. The PCB conductive elements 21 are electrically connected with the corresponding board connectors 132B to ensure the electrical holder 10B to be electrically connected with the flexible circuit board 20, such that the electrical holder 10B can be electrically connected to a power unit.

According to the third embodiment of the present invention, the electrical holder 10B is coupled to the flexible circuit board 20 to electrically connect the electrical holder 10B with the flexible circuit board 20. It is worth mentioning that the PCB conductive elements 21 are provided on the board body 22 and are located corresponding to the locations of the board connectors 132B provided on the electrical holder 10B so as to enable the flexible circuit board 20 be electrically connected with the circuit 12B. The PCB conductive elements 21 are electrically connected with the board connectors 132B provided on the electrical holder 10B, wherein the electrical connection may be embodied but not be limited to soldering connection.

According to the third embodiment of the present invention, each of the board connectors 132B can be embodied as but not be limited to a pin or bonding pad. The electrical holder 10B is electrically connected with the flexible circuit board 20 by soldering. It is appreciated to one skilled in the art that the attaching connection type or soldering connection type are exemplary only and not intended to be limiting. The connection between the electrical holder 10B and the flexible circuit board 20 may be embodied as but not be limited to soldering structure.

The connecting elements 13B of the electronic 10B further comprise a plurality of driver connectors 133B and a plurality of component connectors 134B, wherein the driver connectors 133B are provided on the top surface 1111B of the first holder portion 111B. According to the third embodiment of the present invention, each of the driver connectors 133B can be embodied but not be limited to a pin or bonding pad. The driver connectors 133B are used for electrically connecting the driver 50 with the circuit 12B embedded in the first holder portion 111B, the second holder portion 112B and the third holder portion 113B. It is worth mentioning that the first holder portion 111B, the second holder portion 112B and the third holder portion 113B of the main body 11B can be used for an embedded circuit to further improve available space of necessary components so as to minimize the size of the entire camera module.

According to the third preferred embodiment of the present invention, the driver 50 comprises a plurality of driver conductive elements 51 and a driver body 52, wherein the driver conductive elements 51 are provided at the driver body 52. It is worth mentioning that the driver conductive elements 51 are provided on the driver body 52 and are located corresponding to the locations of the driver connectors 133B provided on the electrical holder 10B such that when the driver 50 is provided at the electrical holder 10B, the driver 50 can be electrically connected with the circuit 12B. More specifically, the driver conductive elements 51 are electrically connected with the driver connectors 133B of the electrical holder 10B, wherein the electrical connection method can be but not be limited to anisotropic conductive paste (ACP), ultrasonic welding, thermal compression soldering and reflow soldering. It is appreciated that the structure of this embodiment can also be used for a fixed-focus camera module without the driver 50.

According to the third embodiment of the present invention, the component connectors 134B are provided on the second top surface 1121B of the second holder portion 112B. The component connectors 134B can be embodied as pins or bonding pads, which can be used for electrically connecting the electronic components 80. It is appreciated to one skilled in the art that the electrical connection between the electronic components 80 and the electrical holder 10B can be embodied but not be limited to soldering.

It is worth mentioning that the electrical holder 10B, according to the third embodiment of the present invention, does not have the through hole. In other word, the third holder portion 113B provided in the middle portion of the main body 11B is configured to have no through hole. So, the third holder portion 113B can be used for configuring circuits, for example, of the electrical elements 121B and the electrical conductors 122B of the circuit 12B. In this way, when the circuit 12B is configured, no wire is needed to pass through the through hole, such that the circuit 12B can be directly configured at the third holder portion 113B, which improves the available space for configuring the circuit 12B and prevents any unusable space at the through hole to prolong the distance of the circuit connection. At the same time, it also helps to decrease the overall dimension of the electrical holder 10B for minimizing the size of the corresponding camera module so as to make it have a good prospect of application in electronic equipments.

The camera module according to the third embodiment is manufactured by coupling the photosensitive chip 30B at an inner side of the electrical holder 10B, locating the optical lens 40B in the photosensitive path of the photosensitive chip 30B, electrically connecting the photosensitive chip 30B with the electrical holder 10B, embedding a plurality of electrical elements 121B and a plurality of electrical conductors 122B in the main body 11B of the electrical holder 10B to form the circuit 12B embedded in the main body 11B and the lens holder 14B, and arrange the connecting elements 13B on the surface of the main body 11B to facilitate the electric conduction of the camera module. The main body 11B is formed by arranging a laminate resin on a reinforcing steel or copper panel to form the first holder portion 111B, the second holder portion 112B and the third holder portion 113B so as to configure the main body 11B with the step-stair structure. The photosensitive chip 30B is provided at the top surface of the third holder portion 113B.

The board connectors 132B are provided on the surface of the main body 11B, and the flexible circuit board 20 is provided on the electrical holder 10B, wherein the circuit 12B is electrically connected with the flexible circuit board 20B by the board connectors 132B. The connection method for electrically connecting the flexible circuit board 20 on the electrical holder 10B and for electrically connecting the flexible circuit board 20 with the circuit 12B is selected from the group including welding, anisotropic conductive paste, ultra sonic press, UV exposure, X-ray exposure, conductive glue, hot pressing, and etc.

The driver connectors 133B are provided on the surface of the main body 11B, and the optical lens 40 is provided on the driver 50 to form a zoom camera module. The driver 50 is provided on the electrical holder 10B, and the circuit 12B is electrically connected with the driver 50 by the driver connectors 133B. The connection method for electrically connecting the driver 50 on the electrical holder 10B and for electrically connecting the driver 50 with the circuit 12B is selected from the group including welding, anisotropic conductive paste, ultra sonic press, UV exposure, X-ray exposure, conductive glue, hot pressing, and etc.

The component connectors 134B are provided on the surface of the main body 11B, and the electronic components 80 are provided on the main body 11B, wherein the electronic components 80 are electrically connected with the circuit 12B by the component connectors 134B. The connection method for electrically coupling the electronic components 80 on the electrical holder 10B is preferably embodied but not limited by a soldering method. The electronic components 80 can be resistances, capacitances, transistor, converter, diode, or driver chips.

The photosensitive chip 30 is formed by extending a lead therefrom by the traditional COB type, to be connected electrically with the chip connectors 131B of the electrical holder 10B. Each of the chip connectors 131B can be embodied as but not be limited to a pin or bonding pad.

Fig. 11 illustrates an electrical conduction method for the camera module of the present invention. As shown in Fig. 11, the electrical conduction method for the camera module comprises the following steps:
S1: arranging a plurality of electrical elements 121 and a plurality of electrical conductors 122 electrically connected with the electrical elements 121 at the main body 11 of the electrical holder 10, wherein the electrical elements 121 and the electrical conductors 122 are connected to form the circuit 12;
S2: electrically connecting the photosensitive chip 30 at the electrical holder 10; and
S3: electrically connecting a flexible circuit board 20 with the electrical holder 10.

The electrical conduction method for the camera module of the present invention further comprises the following steps:
S4: electrically connecting the driver 50 with the electrical holder 10; and
S5: electrically connecting the camera module with an electronic equipment by the flexible circuit board 20 to input control signals therein.

By the above aspects, the components of the camera module of the present invention are electrically connected with each other to make the camera module have a predetermined function.

It is worth mentioning that the step S1 can be embodied as embedding the electrical elements 121 and the electrical conductors 122 in the electrical holder 10.

According to the embodiment, in the step S2, the connection method for connecting electrically the photosensitive chip 30 with the electrical holder 10 is selected from the group including soldering, anisotropic conductive paste, ultra sonic press, UV exposure, X-ray exposure, conductive glue, hot pressing, and etc. In the step S3, the connection method for connecting electrically the flexible circuit board 20 with the electrical holder 10 is selected from the group including soldering, anisotropic conductive paste, ultra sonic press, UV exposure, X-ray exposure, conductive glue, hot pressing, and etc. In the step S4, the connection method for connecting electrically the driver 50 with the electrical holder 10 is selected from the group including soldering, anisotropic conductive paste, ultra sonic press, UV exposure, X-ray exposure, conductive glue, hot pressing, and etc.

It is worth mentioning that the steps S2, S3 and S4 of the above electrical conduction method for the camera module are not arranged in any special order, which can be adjusted in a specific manufacturing process. In addition, when the driver 50 is no longer needed, the step S4 can be omitted.

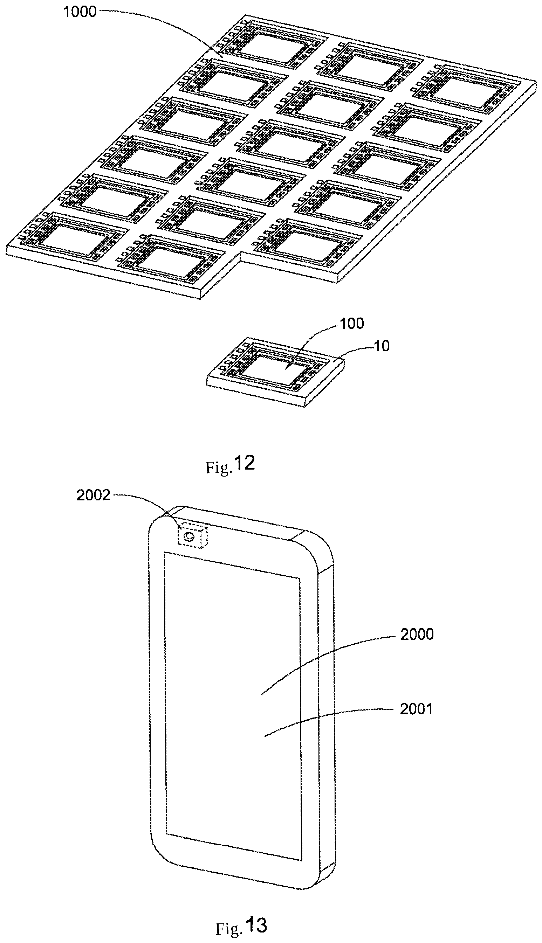

In addition, as shown in Fig.12, the electrical holder of the present invention is adapted to be made by a jointed board. Taking the above electrical holder 10 as an example, an electrical holder jointed board 1000 with a plurality of the integrally formed electrical holders 10 can be formed through the way of laminated resin with embedded electronic components. These electrical holders 10 form an array, and then the electrical holder 10 can be separated by cutting. Thus, it is convenient to produce and improve the production efficiency.

The camera module of the present invention can be applied to various smart electronic devices. The smart electronic devices include but not limited to mobile phone, computer, television, smart wearable device, vehicle, camera, and monitoring apparatus. As shown in Fig.13, it illustrates a smart electronic device 2000. Taking a mobile phone as an example, it comprises a device body 2001, and one or more camera modules 2002 provided in the device body 2001. The camera module 2002 integrated with the electrical holder of the present invention can further reduce the size, especially the thickness size, so that it becomes possible to make the smart electronic device 2000 more thinner.

On the entire structure, the camera module of the present invention has the following advantages different from the traditional COB camera module:
(1) the photosensitive chip and the electrical holder can be electrically connected with each other;
(2) the electrical holder enables capacitances, resistances, driver chips to be embedded therein;
(3) the electrical holder can be configured to have a step-stair configuration to enable the wire to be extended to connect with the chip, wherein the wire is not limited to a gold, aluminum, copper or silver wire;
(4) the electrical holder can be configured to have a step-stair configuration to holder the optical filter;
(5) the electrical holder can be configured to construct with a soldering pad provided on the bottom of the electrical holder, which is electrically connected with the flexible circuit board, wherein the method is not limited to anisotropic conductive paste, soldering or the like.

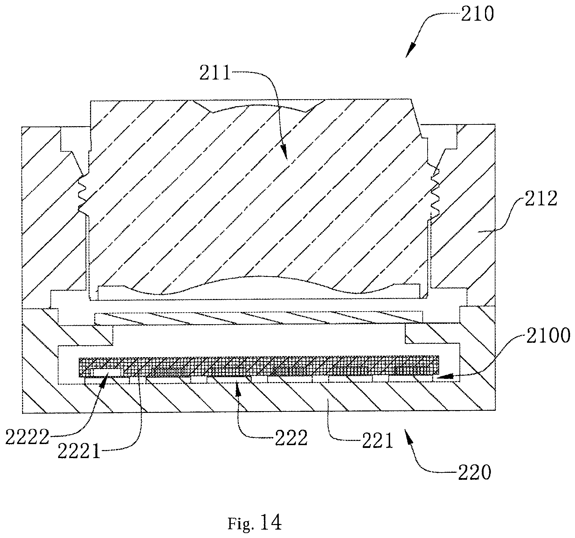

Referring to Figs. 14 to 16, it illuatrates a camera module having a buffer structure according to a fourth embodiment of the present invention. The electrical part of the camera module is provided with a buffer structure so that the circuit elements in the camera module can be installed with buffering. After being mounted, the circuit element can maintain a good structural stability so that the circuit elements in the camera module can reduce the instability caused by the influence of the external environment, such as the camera module being vibrated, shaken, or the like.

The camera module with a buffer structure comprises a lens assembly 210 and a holder assembly 220. The lens assembly 210 is supportably mounted to the holder assembly 220.

In an embodiment of the present invention, the lens assembly 210 comprises a lens 211 and a motor 212. The motor 212 is mounted on the front side of the holder assembly 220, and the lens is mounted on the motor 212, such that the lens 211 is located at the front side of the holder assembly 220.

The holder assembly 220 comprises an electrical holder 221 and an electrical element group 222. The electrical elements are mounted on the electrical holder to form an electrical part of the camera module. That is, the light incident from the lens assembly 210 is projected onto the electrical element group 222 provided on the electrical holder 221, converting the optical information into electrical information and recording the captured image.

The electrical holder 221 comprises a holder part 2211 and a bottom portion 2212. The holder part 2211 is connected to the bottom portion 2212 and is adapted to supportably mount the motor 212. The buffer structure is disposed on the bottom 2212, so that the elements of the electrical element group 222 are buffer-mounted at the bottom 2212.

It should be understood by those skilled in the art that the lens assembly 210 may be a fixed focal lens assembly or a zoom lens assembly. Therefore, the connected elements of the holder part 2211 are not limited to the motor 212, but can be lens holders or other components. The type of the lens assembly 210 is not a limitation of the present invention.

For example, in an embodiment of the present invention, the electrical holder 221 forms a hollow holder-shaped structure by making a groove on a PCB circuit board. The bottom portion 2212 of the electrical holder 221 forms the bottom portion of the groove for disposing the electrical element group 222. The holder part 2211 of the electrical holder 221 forms a side wall of the groove for supporting and connecting the motor 212. Therefore, in this embodiment, the holder part 2211 is integrally connected to the bottom portion 2212. The electrical holder 221 can be molded at one time by molding.

It is worth mentioning that the elements in the electrical element group 222 may be a circuit element, a circuit pin, a soldering pad, a chip, and the like.

In an embodiment of the present invention, the buffer structure 2100 is convexly disposed on the bottom portion 2212 of the electrical holder 221. The buffer structure 2100 is disposed along with an element or a part of elements in the electrical element group 222. Therefore, when the other elements of the electrical element group 222 are press-fitted to the electrical holder 221, the instantaneous pressure applied to the electrical elements on the electrical holder 221 and to the electrical holder 221 is buffered.

According to an embodiment of the present invention, the electrical holder may be formed in a step shape for mounting an IRCF or a lens. The electrical holder enables passive components such as capacitors and resistors to be embedded therein. The electrical holder can be provided with a soldering pad and a pin on the step shape body to interconnect the chip and the motor.

In an embodiment of the present invention, the buffer structure 2100 is disposed at a blank position of the bottom portion 2212 of the electrical holder 221.That is to say, the buffer structure 2100 is disposed at the periphery of the bottom portion 2212 or in an empty position where no electrical elements are mounted.

In another embodiment of the present invention, the buffer structure 2100 is disposed at a peripheral position of each element or a part of the elements in the electrical element group 222. That is to say, the position of the buffer structure 2100 is disposed according to the position of each element of the electrical element group 222. Thus, the instantaneous pressure applied to the corresponding electrical element is buffered.

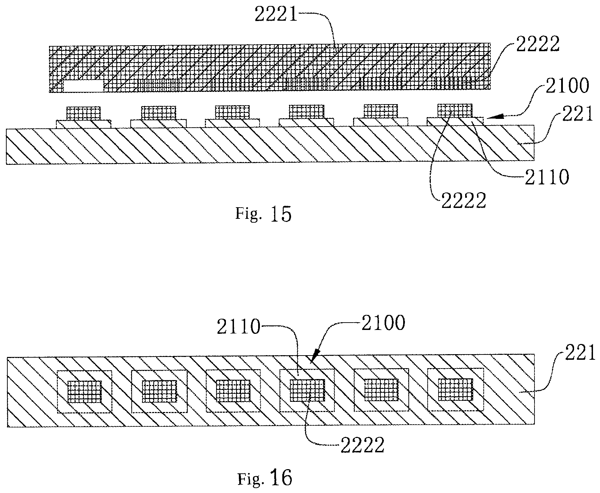

Referring to Figs. 14 and 15, according to an embodiment of the present invention, the electrical element group 222 comprises a photosensitive chip 2221, which is mounted on the bottom portion 2212 of the electrical holder 221. The lens 211 of the lens assembly 210 is located above the photosensitive chip 2221. The light that passes through the lens 211 reaches the photosensitive chip 2221, thereby photosensitive reaction occurs to convert the optical information into electrical information and record the captured image information.

The photosensitive chip 2221 has a circuit pin 2222. The bottom portion 2212 of the electrical holder 221 is provided with a corresponding circuit pin 2222, so that the photosensitive chip 2221 is electrically connected to the electrical element disposed on the bottom portion 2212 of the electrical holder 221.

It is worth mentioning that the photosensitive chip 2221 is assembled by external force compression in a heating or ultrasonic environment. Due to structural limitations of the photosensitive chip 2221 and the electrical holder 221 themselves, there is a difference in surface flatness. Therefore, in the prior art, the force between the photosensitive chip 2221 and the electrical holder 221 is not uniform, which readily leads to the damage of the circuit pin 2222. According to this embodiment of the present invention, the supporting structure is disposed around the circuit pin 2222 disposed on the bottom portion 2212 of the electrical holder 221. As a result, the pressure on the circuit pin 2222 during the press-fitting is buffered, and the force tends to be uniform. The design of raising the buffer structure 2100 can increase the upper limit of the pressure and impact resistance of the overall electrical holder, and reduce the operating difficulty of the pressing process, and increase the reliability of the camera module.

Furthermore, referring to Fig. 16, in an embodiment of the present invention, the buffer structure 2100 is disposed around each or part of the circuit pins 2222. In this embodiment, the height of the buffer structure 2100 is less than the height of the pins. In particular, in an embodiment, the buffer structure 2100 is disposed according to the shape of the circuit pin 2222. For example, when the circuit pin 2222 has a square shape, the buffer structure 2100 surrounds the circuit pin 2222 in a square shape. The top view area of the buffer structure 2100 is greater than the area of the circuit pin 2222, so that the circuit pin 2222 can rapidly reduce the additional pressure when the pressure deformation exceeds the design value. This can ensure that the circuit pin 2222 is not damaged.

According to an embodiment of the present invention, the buffer structure 2100 comprises at least one buffer unit 2110. The buffer unit 2110 is disposed around each or part of the circuit pins 2222. In an embodiment of the present invention, the distribution of the buffer units 2110 are arranged with the distribution of the circuit pins 2222.

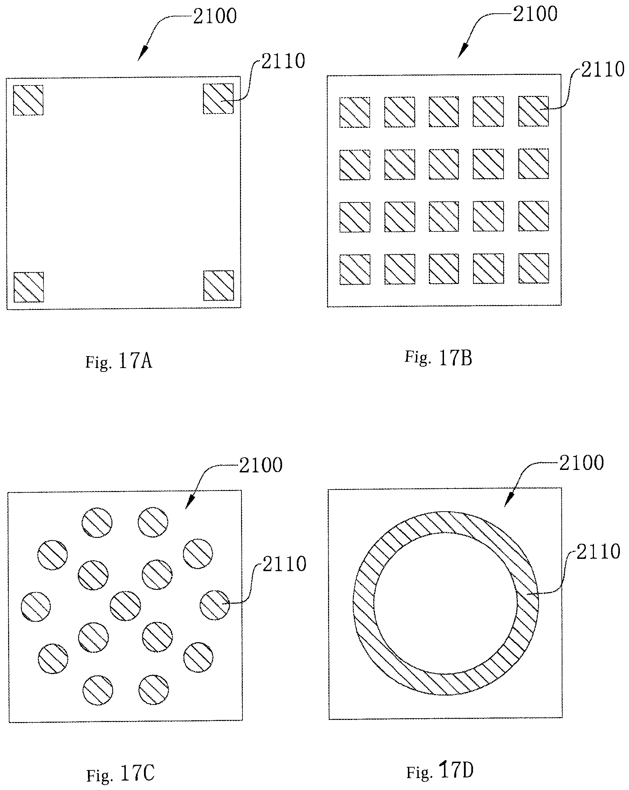

Referring to Figs. 17A to 17D, these figures show the different arrangements of the buffer structure. The arrangement of the buffer structure may be arranged as needed, and is not limited to being disposed around the circuit pin 2222 or in accordance with the shape of the circuit pin 2222.

Referring to Fig. 17A, the buffer unit 2110 of the buffer structure 2100 has a square arrangement. That is, the buffer unit 2110 is disposed on the bottom portion 2212 of the electrical holder 221. The buffer unit 2110 corresponds to the four-corner positions of the photosensitive chips 2221 so as to buffer-support the photosensitive chips 2221 at the four corners of the photosensitive chip 2221.

Referring to Fig. 17B, the buffer units 2110 of the buffer structure 2100 are arranged in a grid, at the bottom portion 2212 of the electrical holder 221, and at the position between the photosensitive chip 2221 and the bottom 2212. Thus, the force applied on the photosensitive chip 2221 and the electrical holder 221 is evenly buffered as a whole during the press fit manufacturing process.

Referring to Fig. 17C, the buffer unit 2110 of the buffer structure 2100 is arranged in a lattice arrangement and is disposed at the bottom portion 2212 of the electrical holder 221, and at the position between the photosensitive chip 2221 and the bottom portion 2212.

Referring to Fig. 17D, the buffer unit 2110 of the buffer structure 2100 is arranged in an annular shape and is disposed at the bottom portion 2212 of the electrical holder 221, and at the position between the photosensitive chip 2221 and the bottom portion 2212. In particular, when each of the buffer units 2110 connects with each other, an annular, continuous buffer structure 2100 is formed.

It is worth mentioning that, according to an embodiment of the present invention, the buffer unit 2110 of the buffer structure 2100 may be disposed with different arrangements as needed, and the shape of the buffer unit 2110 may also be disposed as needed. In the above embodiment of the present invention, the buffer unit 2110 is a hollow square cylinder, and in other embodiments of the present invention is still a different shape.

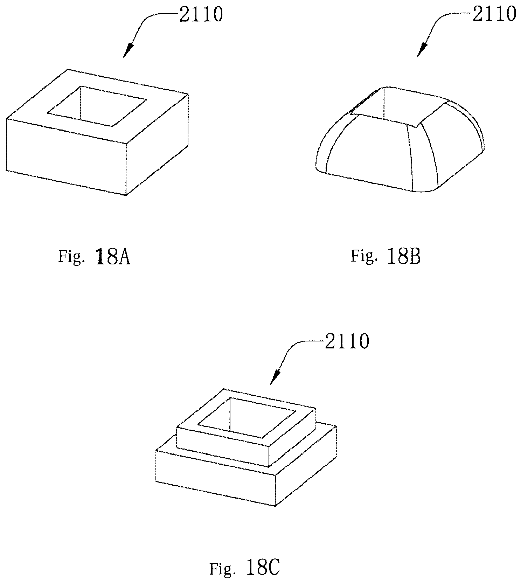

Referring to Figs. 18A to 18C, different shapes of the buffer unit 2110 of the buffer structure 2100 according to the above preferred embodiment of the present invention are illustrated.

Referring to Fig. 18A, when the buffer unit 2110 is disposed according to the circuit pin 2222, and when the structure of the circuit pin is square, the buffer unit 2110 is shaped as a corresponding hollow square cylinder.

Referring to Fig. 18B, the shape of the buffer unit 2110 is a gradual arc structure, so that the buffer of the photosensitive chip 2221 and the electrical holder 221 gradually changes with the shape. The shape of the buffer unit 2110 is more in line with the principles of structural mechanics.

Referring to Fig. 18C, the buffer unit 2110 has a step shape. The buffer of the photosensitive chip 2221 and the electrical holder 221 is gradually changed with the shape. It is easier to manufacture than an arc structure.

In above Figs. 18A, 18B, and 18C, the attached object of the buffer unit 2110 is square and illustrated as an example, the hollow structures are all square. Those skilled in the art should understand that the attached object of the buffer unit 2110 is not limited by the present invention. The buffer unit 2110 may be selectively attached to different objects or disposed independently without attachment. Therefore, the buffer unit may be a hollow structure with different shapes, or it may be a solid structure instead of hollow.

It is worth mentioning that the material of the buffer structure 2100 can be selected from the following combination: one or more of an insulated polymer, a conductive polymer, a metal or a metal oxide.

It is worth mentioning that during the manufacturing process, the buffer structure 2100 can be raised on the bottom portion 2212 of the electrical holder 221 by molded at one time through molding, and thus an integrated convex buffer structure will be formed. In this way, the buffer structure buffers the great press-fitting forces of the electrical elements and the electrical holder 221. In particular, the great press-fitting forces of the connected circuit pins will be buffered.

The height of the buffer structure 2100 is slightly lower than the designed gap formed after press-fitting. Deformation space is reserved for the circuit pin 2222 according to the pressure requirement, so as to ensure that the circuit pin 2222 will be fully pressed.

The holder assembly 220 further comprises an optical filter 223 (color filter). The optical filter 223 is supportably mounted on the holder part 2211 of the electrical holder 221. Furthermore, in an embodiment, the holder part 2211 forms a lug boss type supporting structure to supportably connect the optical filter 223. When the image is captured, the light reflected by the object enters the lens 211. The light reaches the optical filter 223 after the optical action of the lens 211. After the filtering effect of the optical filter, the light reaches the photosensitive chip 2221 located on the bottom portion 2212 of the electrical holder 221. The photosensitive chip 2221 reacts with the light to convert the optical signal into an electrical signal, thereby completes the entire image captured process.

The buffer structure buffers the press-fitting forces between the electrical holder 221 of the holder assembly 220 and the electrical element at the time of assembly, so that the partial pressure on the electrical elements is shared and thus the electrical holders and electrical elements are not easily damaged. Thereby the yield of products is improved. The buffer structure also improves the upper limit of the overall pressure and impact resistance of the holder assembly. The difficulty of the press-fitting process is reduced. The reliability of the camera module is improved. The influence of changes in the external environment, such as vibration, on the stability of the electrical elements in the camera module is reduced.

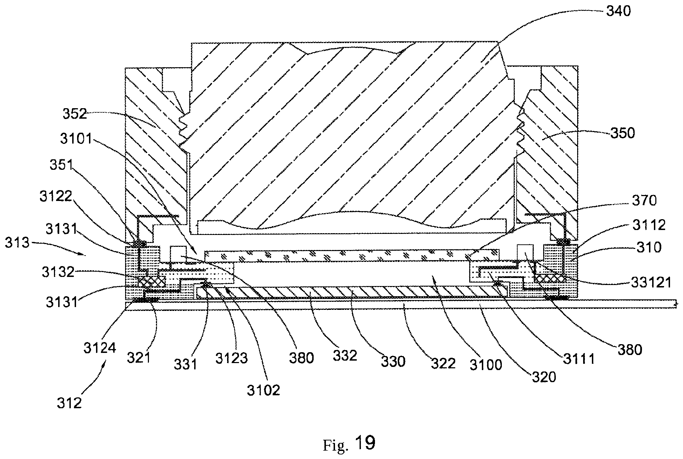

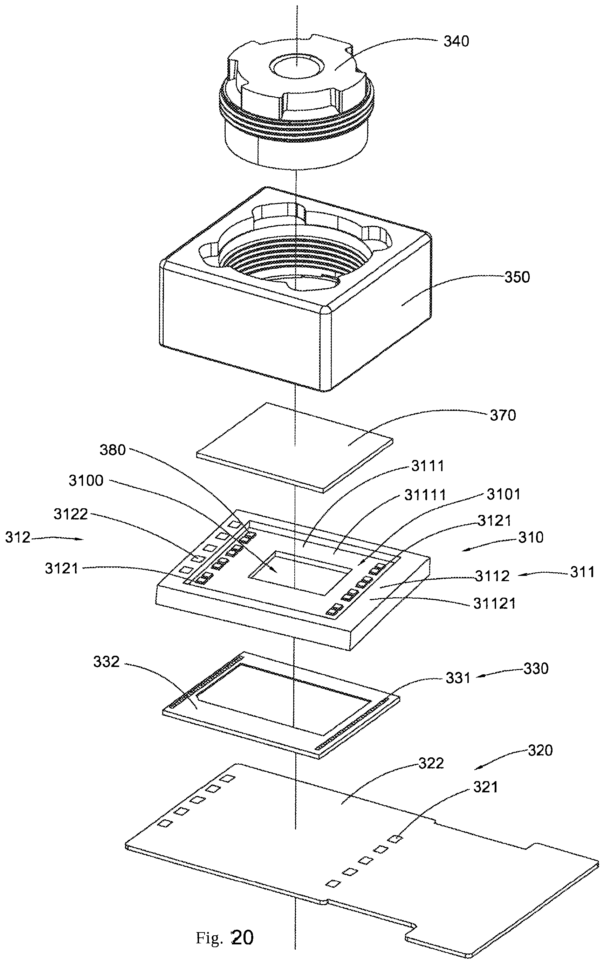

Figs. 19 and 20 illustrate a camera module system according to a fifth preferred embodiment of the present invention. The camera module comprises an electrical holder 310, a flexible circuit board 320, a photosensitive chip 330, an optical lens 340, and a motor 350. It can be understood that the motor 350 herein is used as a focusing mechanism to change the camera module system of the present invention into an autofocus camera module. The camera module of the present invention may also be free of the above-mentioned motor 350, so that the camera module is a fixed focal camera module.

The optical lens 340 is mounted to the motor 350, and the optical lens 340 may be driven by the motor 350 to be suitable for auto focusing. The optical lens 340 is located on the photosensitive path of the photosensitive chip 330. When the camera module is used to capture an image of an object, the light reflected by the object can be further accepted by the photosensitive chip 330 after being processed by the optical lens 340, to be suitable for photoelectric conversion. According to the first preferred embodiment of the present invention, the electrical holder 310 may be used to connect the flexible circuit board 320 and the motor 350. That is to say, the electrical holder 310 also integrates the functions of the base and the circuit board of the traditional camera module to assemble the motor 350, the optical lens 340, and may be electrically connected the motor 350, the photosensitive chip 330, and the flexible circuit board 320.

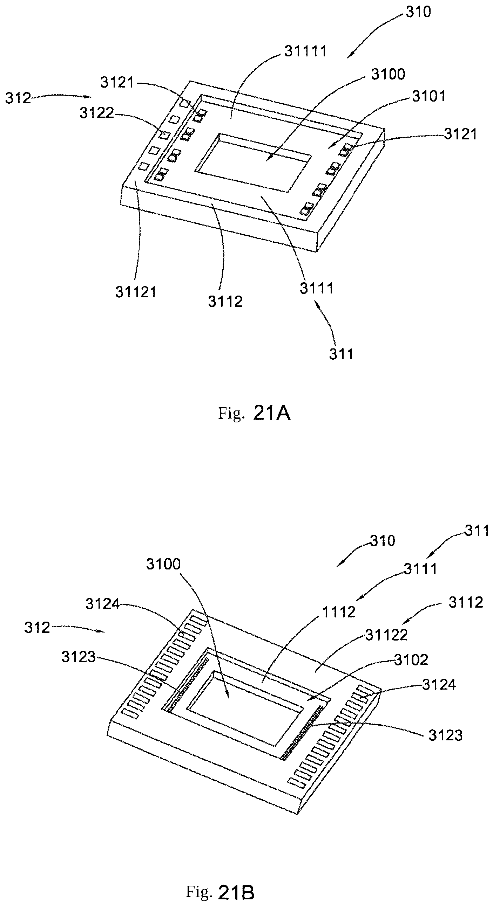

As shown in Figs. 21A and 21B, the electrical holder 310 comprises a holder body 311, a plurality of connecting elements 312 and a circuit 313, and has a through hole 3100. According to the first preferred embodiment of the present invention, the holder body 311 comprises a first holder part 3111 and a second holder part 3112. It can be understood that the above division of the first and second holder parts 3111 and 3112 is only for convenience of description. The first holder part 3111 and the second holder part 3112 are integrally molded. The holder body 311 has a first top surface 31111, a first bottom surface 31112, a second top surface 31121, and a second bottom surface 31122. More particularly, the first holder part 3111 of the holder body 311 has the first top surface 31111 and the first bottom surface 31112. The second holder part 3112 has the second top surface 31121 and the second bottom surface 31122. The circuit 313 is provided on the holder body 311. More particularly, the circuit 313 is embedded in the holder body 311.

The circuit 313 comprises a set of electrical conductors 3131 and a plurality of electronic components 3132. The set of electrical conductors 3131 can be electrically connected to the electronic components 3132 in a predetermined manner. The circuit 313 can be electrically connected to the motor 350, the flexible circuit board 320, and the photosensitive chip 330 in a predetermined manner. In this way, the elements of the camera module can be electrically connected in a predetermined manner, so that the camera module has a predetermined function. The connection element 312 is electrically connected to the electrical conductor 3131 and the electronic components 3132. The electronic components 3132 may be various resistors, capacitors, or driving elements, and so on.

The photosensitive chip 330 is electrically connected to the circuit 313 of the electrical holder 310 and the flexible circuit board 320. Particularly, the photosensitive chip 330 is adhesively mounted on the holder body 311 of the electrical holder 310 and is electrically connected to the circuit 313 of the electrical holder 310. The electrical holder 310 is adhesively mounted on the flexible circuit board 320. The photosensitive chip 330 is electrically connected to the flexible circuit board 320 through the circuit 313 of the electrical holder 310.

According to the first preferred embodiment of the present invention, the camera module further comprises a plurality of electronic components 380. The electronic component 380 may be various resistors, capacitors, or driving elements, etc., and may raise from the first top surface 31111. Those skilled in the art should understand that the camera module including a plurality of electronic component 380 is only an example of the present invention, and is not limited thereto. In applications, all the electronic components and electronic components may be embedded in the electrical holder 310, or the electronic component 380 may be raised and provided on the surface of the electrical holder 310.

The connecting element 312 is disposed on the holder body 311 and can be electrically connected to the photosensitive chip 330, the motor 350, and the flexible circuit board 320 of the camera module. Particularly, the connecting element 312 is disposed on the surface of the holder body 311, namely, the first top surface 31111, the first bottom surface 31112, the second top surface 31121, and the second bottom surface 31122, s as to facilitate the power connection with the photosensitive chip 330, the motor 350, and the flexible circuit board 320. More particularly, the connecting element 312 comprises a series of electronic component conductive elements 3121, a series of motor conductive elements 3122, a series of photosensitive chip conductive elements 3123, and a series of flexible circuit board conductive elements 3124, which are used to connect and conduct the electronic component 380, the motor 350, the photosensitive chip 330, and the flexible circuit board 320, respectively.

The electronic component conductive element 3121, the motor conductive element 3122, the photosensitive chip conductive element 3123, and the flexible circuit board conductive element 3124 are all disposed on the surface of the holder body 311, namely, the first top surface 31111, the first bottom surface 31112, the second top surface 31121, or the second bottom surface 31122. More particularly, the electronic component conductive element 3121 is disposed on the first top surface 31111. Thus, the electronic component 380 is conveniently disposed on the first top surface 31111, and electrically conducted to the circuit 313 of the electrical holder 310. The motor conductive element 3122 is disposed on the second top surface 31121, and thus the motor 350 is conveniently disposed on the second top surface 31121 and electrically conducted to the circuit 313 of the electrical holder 310. The photosensitive chip conductive element 3123 is disposed on the first bottom surface 31112, and thereby the photosensitive chip 330 is conveniently disposed on the first bottom surface and is electrically conducted to the circuit 313 of the electrical holder 310. The flexible circuit board conductive element 3124 is disposed on the second bottom surface 31122, and thus the flexible circuit board 320 is conveniently disposed on the second bottom surface 31122 and is electrically conducted to the circuit 313 of the electrical holder 310.

The motor conductive element 3122 is used to electrically connecting the motor 350 with the circuit 313, so that the motor 350 can be driven and further drive the optical lens 340 to adjust the camera module.

The photosensitive chip conductive element 3123 can be electrically connected with the circuit 313. The flexible circuit board conductive element 3124 can be electrically connected with the circuit 313. The photosensitive chip 330 comprises a plurality of photosensitive chip conductive elements 331 and a photosensitive chip body 332. The photosensitive chip conductive element 331 is disposed on the photosensitive chip body 332. It is worth mentioning that the position of the photosensitive chip conductive element 331 on the photosensitive chip body 332 is corresponding to the position of the photosensitive chip conductive element 3123 of the electrical holder 310. Therefore, when the photosensitive chip 330 is mounted to the electrical holder 310, the photosensitive chip 330 can be electrically connected with the circuit 313 of the electrical holder 310, and further electrically connected with the flexible circuit board 320. The photosensitive chip 330 may be mounted to the electrical holder 310 by a flip chip process without a wire bonding process. The connection manner between the photosensitive chip conductive element 331 and the photosensitive chip conductive element 3123 may be, but not limited to, ACP (inverted conductive adhesive), ultrasonic welding, hot pressing bonding, and reflow soldering.

The flexible circuit board 320 comprises a plurality of circuit board conductive elements 321 and a circuit board body 322, wherein the circuit board conductive elements 321 are disposed on the circuit board body 322. It is worth mentioning that the position of the circuit board conductive element 321 on the circuit board body 322 is corresponding to the position of the flexible circuit board conductive element 3124 of the electrical holder 310. Therefore, when the flexible circuit board 320 is mounted on the electrical holder 310, the flexible circuit board 320 can be electrically connected with the circuit 313 of the electrical holder 310, and can be further electrically connected with the photosensitive chip 330 and the motor 350. More particularly, the circuit board conductive element 321 is electrically connected with the flexible circuit board conductive element 3124 of the electrical holder 310, and the power connection can be but not limited to welding.

It is worth mentioning that the flexible circuit board 320 and the electrical holder 310 being disposed separately is just an example of the present invention instead of a limit thereto. According to other embodiments of the present invention, the flexible circuit board 320 may also be integrated with the electrical holder 310. In addition, the respective shapes or the integral shape of the flexible circuit board 320 and the electrical holder 310 may be disposed as required.

The motor 350 comprises a plurality of motor conductive elements 351 and a motor body 352, wherein the motor conductive elements 351 are disposed on the motor body 352. It is worth mentioning that the position of the motor conductive element 351 on the motor body 352 is corresponding to the position of the motor conductive element 3122 on the electrical holder 310. Therefore, when the motor 350 is mounted on the electrical holder 310, the motor 350 can be electrically connected with the circuit 313 of the electrical holder 310, and further electrically connected with the flexible circuit board 320. More particularly, the motor conductive element 351 is electrically connected with the motor conductive element 3122 of the electrical holder 310, and the connection manner may be, but not limited to, ACP (inverted conductive adhesive), ultrasonic welding, hot pressing bonding, and reflow soldering.

According to the preferred embodiment of the present invention, each connecting element 312 is embodied as a terminal pad which is the same part in conventional camera module to reduce the manufacturing cost of the camera module. Particularly, each of the electronic component conductive elements 3121 is embodied as an electronic component terminal pad. Each of the motor conductive elements 3122 is embodied as a motor terminal pad. Each of the photosensitive chip conductive elements 3123 is embodied as a photosensitive chip terminal pad. Each of the flexible circuit board conductive elements 3124 is embodied as a flexible circuit board terminal pad. It is worth mentioning that, according to the preferred embodiment of the present invention, each of the connecting elements 312 can also be embodied as a soldering pad. One skilled in art can understand that using the soldering pad is exemplary only and not intended to be limiting. According to other embodiments of the present invention, the connecting elements 312 can also be embodied as any other possible method to achieve electrical conduction.

As shown in Fig. 20, the camera module 30 further comprises an optical filter 370, which is used to filter out stray light, in order to further enhance the quality of the image. The first top surface 31111 is indented from the second top surface 31121 to provide a storing and protective space for the electronic component 380 and the optical filter 370. The first bottom surface 31112 is indented from the second bottom surface 31122 to provide a storing and protective space for the photosensitive chip 330 and the flexible circuit board 320.

As shown in Figs. 19 and 20, it can also be that, the electrical holder 310 of the present invention is modified from a conventional PCB board in order to omit the base of the conventional camera module. The electrical holder 310 has an PCB circuit formed integrally, and forms inside a top groove 3101, a through hole 3100 and a bottom groove 3102 in this embodiment. The top groove 3101 and the bottom groove 3102 are respectively positioned on the top side and the bottom side of the through hole 3100. The inner diameter of each of the top groove 3101 and the bottom groove 3102 is larger than that of the through hole 3100, and the top groove 3101 and the bottom groove 3102 are configured to make the electrical holder 310 have a step shape configuration on the top side and the bottom side. That is, the first top surface 31111 and the second top surface 31121 form a non-coplanar stepped surface, and the first bottom surface 31112 and the second bottom surface 31122 form a non-coplanar stepped surface.

The electronic component 380 and the optical filter 370 may be arranged in the top groove 3101 of the electrical holder 310, wherein the electrical holder 310 is also used to mount the optical filter 370. The photosensitive chip 330 is provided in the bottom groove 3102, and the outer top surface is connected with the first bottom surface 31112 of the electrical holder 310, so that the photosensitive chip 330 of the present invention can use flip chip method to mount. One skilled in the art can understand that the light travelling through the optical lens 340 will be filtered by the optical filter 370, and will then travels through the through hole 3100 to reach the photosensitive chip 330.

One skilled in the art will understand that position arrangement of the above mentioned electronic component conductive elements 3121, the motor conductive elements 3122, the photosensitive chip conductive elements 3123 and the flexible circuit board conductive elements 3124, the configuration of the first top surface 31111 in relative with the second top surface 31121, as well as the configuration of the first bottom surface 31112 in relative with the second bottom surface 31122 are exemplary only and not intended to be limiting. The invention comprises all modifications encompassed within the spirit and scope of the present invention. According to other embodiments of the present invention, there may be other ways of disposing, for example, the first top surface 31111 is in the same plane with the second top surface 31121. It is also possible that the second top surface 31121 is concave downward with respect to the first top surface 31111.

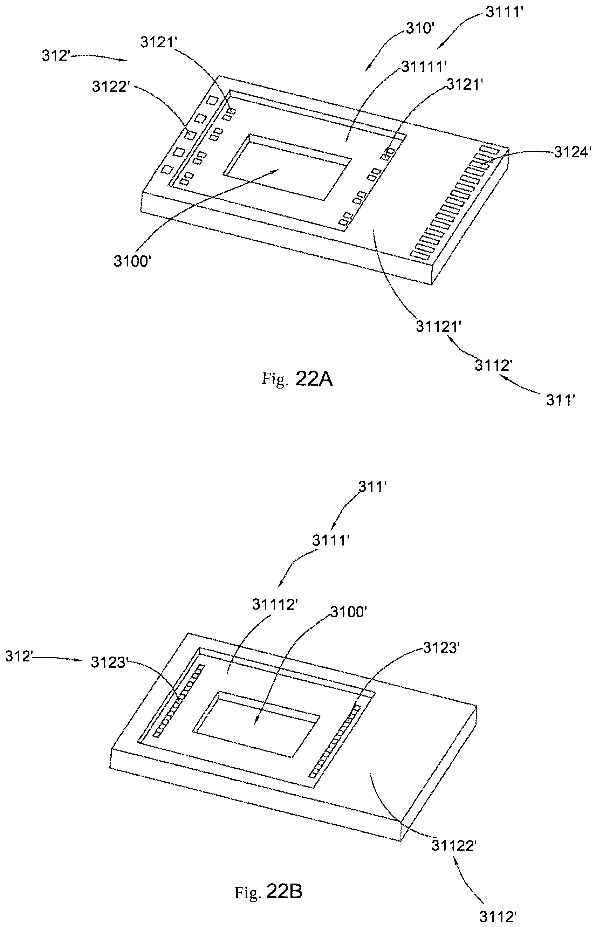

Figs. 22A and 22B illustrate a first alternative embodiment of an electrical holder 310' of the camera module according to the preferred embodiment of the present invention. Besides the electrical holder 310', other structural configuration of the camera module of the first alternative embodiment is the same as the first preferred embodiment of the present invention. As shown in the figures, the electrical holder 310' comprises a holder body 311', a plurality of connecting elements 312' and a through hole 3100'. According to the first alternative embodiment of the present invention, the holder body 311' comprises a first holder part 3111' and a second holder part 3112', wherein the first holder part 3111' and the second holder part 3112' is integrally formed. The holder body 311' has a first top surface 31111', a first bottom surface 31112', a second top surface 31121' and a second bottom surface 31122'. Particularly, the first holder part 3111' of the holder body 311' has the first top surface 31111' and the first bottom surface 31112', while the second holder part 3112' has the second top surface 31121' and the second bottom surface 31122'. The circuit 313 is embedded in the holder body 311'.

The connecting element 312' comprises a plurality of electronic component conductive elements 3121', a plurality of motor conductive elements 3122', a plurality of photosensitive chip conductive elements 3123' and a plurality of flexible circuit board conductive elements 3124' for connecting and conducting the electronic components 380, the motor 350, the photosensitive chip 330 and the flexible circuit board 320, respectively.

The electronic component conductive elements 3121' are provided on the first top surface 31111', wherein the motor conductive elements 3122' are provided on the second top surface 31121'. The flexible circuit board conductive elements 3124' are provided on the second top surface 31121'. The photosensitive chip conductive elements 3123' are provided on the first bottom surface 31112'. The first top surface 31111' is indented from the second top surface 31121'. The first bottom surface 31112' is indented from the second bottom surface 31122'.

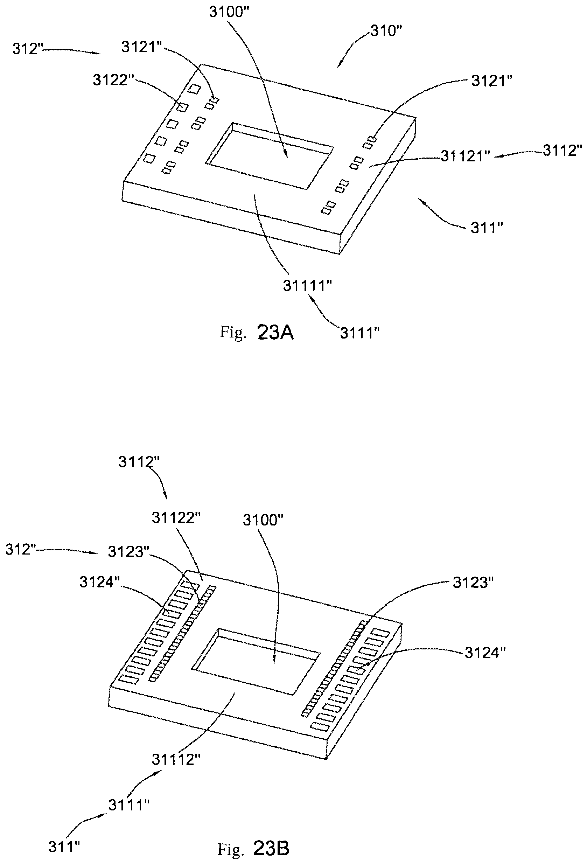

Figs. 23A and 23B illustrate a second alternative embodiment of an electrical holder 310" of the camera module according to the preferred embodiment of the present invention. Besides the electrical holder 310", other structural configuration of the camera module according to the second alternative embodiment is the same as the preferred embodiment of the present invention. The electrical holder 310" comprises a holder body 311", a plurality of connecting elements 312" and a through hole 3100". According to the second alternative embodiment of the present invention, the holder body 311" comprises a first holder part 3111" and a second holder part 3112", wherein the first holder part 3111" and the second holder part 3112" is integrally formed. The holder body 311" has a first top surface 31111 ", a first bottom surface 31112", a second top surface 31121" and a second bottom surface 31122". Particularly, the first holder part 3111" of the holder body 311" has the first top surface 31111" and the first bottom surface 31112", and the second holder part 3112" has the second top surface 31121" and the second bottom surface 31122". The circuit 313 is embedded in the holder body 311".

The connecting element 312" comprises a plurality of electronic component conductive elements 3121", a plurality of motor conductive elements 3122", a plurality of photosensitive chip conductive elements 3123" and a plurality of flexible circuit board conductive elements 3124" for connecting and conducting the electronic components 380, the motor 350, the photosensitive chip 330 and the flexible circuit board 320, respectively.

The electronic component conductive elements 3121" are provided on the first top surface 31111". The motor conductive elements 3122" are provided on the second top surface 31121". The flexible circuit board conductive element 3124" is provided on the second top surface 31121". The photosensitive chip conductive elements 3123" are provided on the first bottom surface 31112". The first top surface 31111" is in the same plane with the second top surface 31121", which form an integral top surface in the same plane. The first bottom surface 31112" is in the same plane with the second bottom surface 31122", which form an integral bottom surface in the same plane. At this point, the photosensitive chip 330 is suitable for mounting on the bottom of the electrical holder 310" using flip chip method.

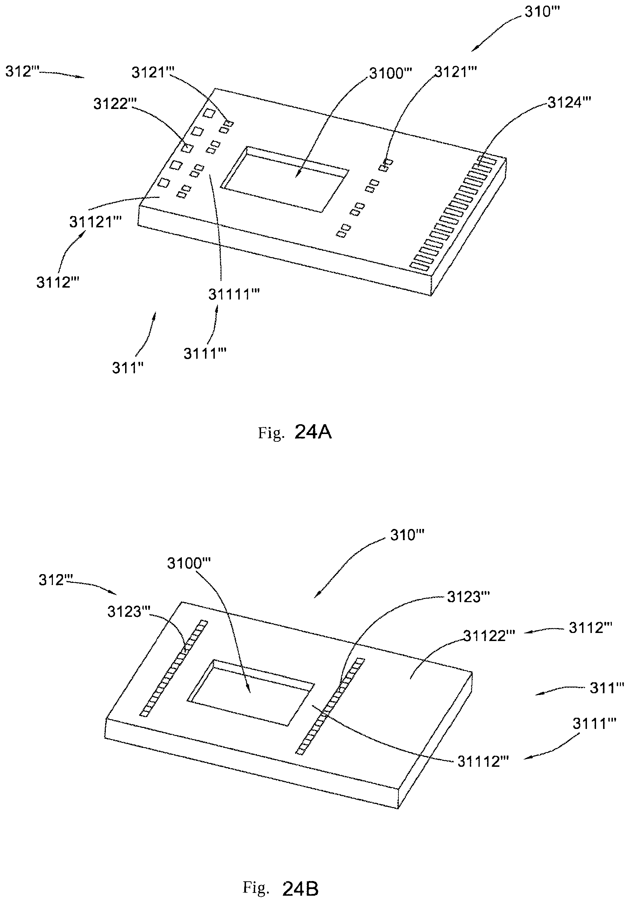

Figs. 24A and 24B illustrate a third alternative embodiment of an electrical holder 10" of the camera module according to the preferred embodiment of the present invention. Besides the electrical holder 310"', other structural configuration of the camera module according to the third second alternative embodiment is the same as the above-mentioned preferred embodiment of the present invention. The electrical holder 310"' comprises a holder body 311'", a plurality of connecting elements 312'" and a through hole 3100'". According to the third second alternative embodiment of the present invention, the holder body 311'" comprises a first holder part 3111'" and a second holder part 3112"', wherein the first holder part 3111'" and the second holder part 3112'" is integrally formed. The holder body 311'" has a first top surface 31111"', a first bottom surface 31112'", a second top surface 31121"' and a second bottom surface 31122'". Particularly, the first holder part 3111'" of the holder body 311'" has the first top surface 31111'" and the first bottom surface 31112'", while the second holder part 3112'" has the second top surface 31121'" and the second bottom surface 31122"'. The circuit 313 is embedded in the holder body 311'".

The connecting element 312'" comprises a plurality of electronic component conductive elements 3121"', a plurality of motor conductive elements 3122'", a plurality of photosensitive chip conductive elements 3123'" and a plurality of flexible circuit board conductive elements 3124"' for connecting and conducting the electronic components 380, and the motor 350, the photosensitive chip 330 and the flexible circuit board 320, respectively.

The electronic component conductive elements 3121'" are provided on the first top surface 31111"'. The motor conductive elements 3122'" are provided on the second top surface 31121'". The photosensitive chip conductive elements 3123"' are provided on the first bottom surface 31112"'. The flexible circuit board conductive elements 3124'" are provided on the second bottom surface 31122'". The first top surface 31111"' is in the same plane with the second top surface 31121"', which form an integral top surface at the same level. The first bottom surface 31112'" is in the same plane with the second bottom surface 31122'", which form an integral bottom surface at the same level. The photosensitive chip 330 is suitable to be mounted on the bottom of the electrical holder 310" using flip chip method.

In the overall structural scheme, the present invention has some new features over the conventional COB package as the following.

For the camera module serving as an autofocus camera module, when the motor is mounted to the electrical holder, the electrical property of both parts is conducted by the motor soldering pad and the motor conductive element. The conductive method could be soldering, and preferably using conductive silver paste. Thus, after the mounting of the motor, no further soldering process is needed.

The optical filter is attached to the surface of the electrical holder instead of attaching to an interior of the lens or a separate designing base.

The photosensitive chip is attached to the electrical holder by using flip chip method, without being limited by the wire bonding process. For example, the connecting method of the photosensitive chip conductive element 331 and the photosensitive chip conductive element 3123 could be but not limited to ACP (anisotropic conductive paste), ultrasonic welding, hot pressing bonding, reflow soldering.

More than one set of conductive points is provided on the outside of the electrical holder, such as (1) the motor conductive soldering pad, (2) the flexible printed conductive soldering pad, and (3) the photosensitive chip conductive soldering pad inside the electrical holder.

Resistors, capacitors and driver IC can be embedded into the electrical holder with various predetermined shapes, thus the design of the electrical holder is flexible.

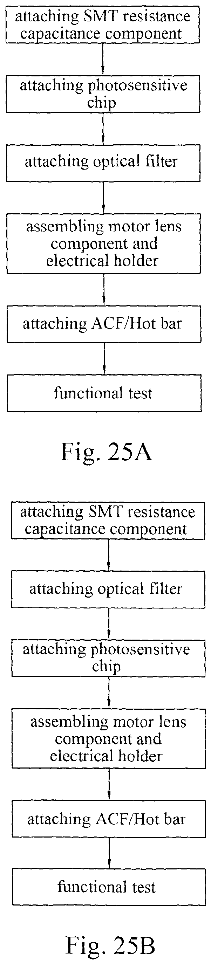

Figs. 25A and 25B illustrate a manufacturing method of a camera module according to the present invention. As shown in the figures, the manufacturing method of the camera module comprises the following steps.
S10: attaching the resistors, capacitors and other electrical parts with SMT technology;
S20: attaching the photosensitive chip;
S30: attaching the optical filter;
S40: assembling the motor lens with the electrical holder;
S50: attaching the ACF/Hot bar; and
S60: testing the function of the camera module.

Wherein in the step S10, SMT refers to surface mount technology. Particularly, this step 10 refers to the manner in which the electronic components 380 is integrally formed on the electrical holder 310, 310', 310", 310'" and its alternatives.

Step S20 refers to a step of attaching the photosensitive chip330 to the electrical holder 310, 310', 310", 310"' and its alternatives.

Step S30 refers to a step of attaching the optical filter370 to the electrical holder 310, 310', 310", 310'" and its alternatives.

Step S40 particularly refers to a step of attaching the motor 350 to the electrical holder 310, 310', 310", 310"' and its alternatives. One skilled in the art will understand that for those fixed focal camera module which does not equipped with a motor, the step S40 could be omitted. Alternatively, the optical lens 340 can mounted to the electrical holder directly.

In step S50, the ACF refers to Anisotropic Conductive Adhesive. The Hot bar refers to a pulse heating reflow soldering heating head for soldering related corresponding electrical parts. Particularly, the step S50 refers to a step of electrically connecting the electronic component 380, the photosensitive chip 330, the optical filter 370 and/or the motor 350 to the electrical holder 310, 310', 310". 310"' in the embodiment and its alternatives, the connecting method could be but not limited to ACP (anisotropic conductive paste) and soldering.

Step S60 refers to a step of functional test of the assembled camera module which is formed from the previous steps.

It is worth mentioning that the step S20 and the step S30 are interchangeable.

In addition, in this embodiment, the electrical holder of the present invention is also adapted to make through the way of a jointed board. Taking the above electrical holder 310 as an example, an electrical holder jointed board with a plurality of the integrally formed electrical holder 310 can be formed through the way of laminated resin and embedding electronic components. These electrical holders 310 form an array, and then separate electrical holder 310 can be obtained by cutting. Thus it is convenient to produce and improve the production efficiency.

One skilled in the art will understand that the embodiment of the present invention as shown in the drawings and described above is exemplary only and not intended to be limiting. It will thus be seen that the objects of the present invention have been fully and effectively accomplished. The embodiments have been shown and described for the purposes of illustrating the functional and structural principles of the present invention and is subject to change without departure from such principles.

## Claims

1. An electrical holder (10; 310) for at least a camera module which comprises a photosensitive chip (30; 330), comprising:
a main body (11; 311); and
a circuit arrangement (12; 313) integrated within said main body, wherein said circuit arrangement (12; 313) is arranged for electrically connecting to the photosensitive chip (30; 330), and wherein the photosensitive chip (30; 330) is suitable for being arranged inside the electrical holder and is positioned within the electrical holder;
**characterized in that** said circuit arrangement (12; 313) comprises a plurality of electrical elements (121; 3132) and a plurality of electrical conductors (122; 3131), wherein said electrical conductors are electrically connected with said electrical elements, wherein said electrical elements (121) are embedded in said main body (11); and wherein a plurality of motor conductive members (133; 3122) are provided on the top surface of the main body (11; 311), which can be electrically connected with a motor (50; 350) of the camera module.

2. The electrical holder, as recited in claim 1, further comprising a plurality of connecting elements (13) provided at said main body (11) and electrically connected with said circuit arrangement (12).

3. The electrical holder, as recited in claim 1, wherein the electrical holder (10) comprises a plurality of connecting elements (13) provided at said main body (11), wherein said connecting elements are arranged for electrically connecting at least one lead extended from the photosensitive chip by COB type; or
wherein said main body (11) has a through hole (100) for receiving the photosensitive chip (30) therein; or
wherein said electrical holder has an indented groove, wherein said photosensitive chip (30) is installed in the indented groove.

4. The electrical holder (10), as recited in claim 2, wherein said electrical holder further comprises a plurality of electronic components (80) provided on a surface of said main body (11) in a protruding manner, wherein each of the electronic components is selected from a group consisting of resistance, a capacitance, transistor converter, diode, and driver chip.

5. The electrical holder (10), as recited in claim 1, further comprising a lens supporter for supporting an optical lens of the camera module, wherein said main body has a first supporting portion (111) that supports said lens supporter and said circuit arrangement is embedded in said main body (11), and
preferably wherein said circuit arrangement is extended and embedded in said main body, wherein said lens supporter is electrically connected with said main body via connecting elements by a means selected from the group consisting of soldering, anisotropic conductive paste, ultra sonic press, UV exposure, X-ray exposure, conductive glue, and hot pressing.

6. The electrical holder (10), as recited in claim 2,
wherein said connecting elements (13) are chip connectors electrically connected with said circuit arrangement (12) for electrically connecting to the photosensitive chip (30), wherein said photosensitive chips is electrically connected with said circuit arrangement via said chip connectors by a means selected from the group consisting of soldering, anisotropic conductive paste, ultra sonic press, UV exposure, X-ray exposure, conductive glue, and hot pressing, or
wherein said connecting elements (13) are board connectors electrically connected with said circuit arrangement (12) for electrically connecting to a flexible circuit board (20) of the camera module, wherein said flexible circuit board is electrically connected with said circuit arrangement via said board connectors by a means selected from the group consisting of soldering, anisotropic conductive paste, ultra sonic press, UV exposure, X-ray exposure, conductive glue, and hot pressing, or
wherein said connecting elements (13) comprises a plurality of different connectors for electrically connecting different electronic components of said camera module with said circuit arrangement (12), wherein said electric connection method between said different connectors and said circuit arrangement is selected from the group including soldering, anisotropic conductive paste, ultra sonic press, UV exposure, X-ray exposure, conductive glue, hot pressing, and etc.,
and preferably wherein said connecting elements can be embodied as a bonding pad or a pin.

7. The electrical holder (10), as recited in claim 1 to 6, wherein said electrical holder comprises a first supporting portion (111) and a second supporting portion (112), wherein an inner side of said first supporting portion and a top side of the second supporting portion form a first indented groove while said second supporting portion has a second indented groove.

8. The electrical holder (10), as recited in claim 7, wherein said main body comprises a third supporting portion (113), wherein said third supporting portion is inwardly extended from said second supporting portion, wherein said chip connectors are provided on a top surface of said third supporting portion for electrically connecting with the photosensitive chip (30); or
wherein said main body (11) comprises a first supporting portion (111), a second supporting portion (112) and a third supporting portion (113), wherein said third supporting portion is inwardly indented corresponding to said second supporting portion, wherein an inner side of said first supporting portion and a top side of said second supporting portion form a first indented groove, a top side of said third supporting portion has a second indented groove, and an inner side of said third supporting portion has a third indented groove, wherein said first indented groove, said second indented groove and said third indented groove form a through hole; or
wherein said main body (11) comprises a first supporting portion (111), a second supporting portion (112) and a third supporting portion (113), wherein an inner side of said first supporting portion and a top side of said second supporting portion form a first indented groove, a top side of said third supporting portion has a second indented groove, wherein said first indented groove and said second indented groove form an integrated groove, wherein said third supporting portion forms a base and has a bottom serving as a bottom of said integrated groove, and preferably wherein said chip connectors of the camera module are provided on an inner surface of said second supporting portion or the top side of said third supporting portion.

9. The electrical holder (10), as recited in claim 7, wherein an inner side of said second supporting portion (112) has a second indented groove, wherein said photosensitive chip is provided at said second indented groove.

10. The electrical holder (10), as recited in claim 1, wherein said camera module is a zoom camera module to incorporate with the electrical holder.

11. The electrical holder (10), as recited in claim 10, wherein said electrical holder comprises a plurality of connecting elements (13), wherein said connecting elements are electrically connected with said circuit arrangement (12).

12. The electrical holder (10), as recited in claim 11, wherein each of said electrical elements is selected from the group including resistance, capacitance, transistor, converter, diode, driver chip, and etc., and preferably wherein the electrical holder further comprises a plurality of electronic components (80) provided on a surface of said main body (11) in a protruding manner, wherein each of the electronic components is selected from a group consisting of resistance, a capacitance, transistor converter, diode, and driver chip.

13. The electrical holder (10), as recited in claim 11,
wherein said connecting elements (13) are chip connectors electrically connected with said circuit arrangement (12) for electrically connecting to the photosensitive chip (30), wherein said photosensitive chips is electrically connected with said circuit arrangement via said chip connectors by a means selected from the group consisting of soldering, anisotropic conductive paste, ultra sonic press, UV exposure, X-ray exposure, conductive glue, and hot pressing; or
wherein said connecting elements (13) are board connectors electrically connected with said circuit arrangement (12) for electrically connecting to a flexible circuit board (20) of the camera module, wherein said main body (11) is electrically connected with the flexible circuit board via said board connectors by a means selected from the group consisting of soldering, anisotropic conductive paste, ultra sonic press, UV exposure, X-ray exposure, conductive glue, and hot pressing; or
wherein said connecting elements (13) comprises a plurality of different connectors for electrically connecting different electronic components (80) of said camera module with said circuit arrangement (12), wherein said electric connection method between said different connectors and said circuit arrangement is selected from the group including soldering, anisotropic conductive paste, ultra sonic press, UV exposure, X-ray exposure, conductive glue, hot pressing, and etc..; or
wherein said connecting elements (13) comprises a plurality of driver connectors for electrically connecting a electrical holder of said camera module with said circuit arrangement, wherein said electric connection method between said driver connectors and said circuit arrangement is selected from the group including soldering, anisotropic conductive paste, ultra sonic press, UV exposure, X-ray exposure, conductive glue, hot pressing, and etc.;
and preferably wherein said connecting elements can be embodied as a bonding pad or a pin.

14. The electrical holder (10), as recited in claim 10 - 13, wherein said main body (11) comprises a first supporting portion (111) and a second supporting portion (112), wherein an inner side of said first supporting portion and a top side of said second supporting portion form a first indented groove while said second supporting portion has a second indented groove.

15. The electrical holder (10), as recited in claim 14, wherein said chip connectors of the camera module are provided an inner surface of said second supporting portion (112); or
wherein an inner side of said second supporting portion (112) has a second indented groove, wherein said photosensitive chip is provided at said second indented groove.

16. The electrical holder (10), as recited in claim 14,
wherein said main body (11) comprises a third supporting portion (113), wherein said third supporting portion is inwardly extended from said second supporting portion, wherein said chip connectors are provided on a top surface of said third supporting portion for electrically connecting with the photosensitive chip; or
wherein said main body (11) further comprises a third supporting portion (113), wherein said third supporting portion is inwardly indented corresponding to said second supporting portion, wherein a top side of said third supporting portion forms a second indented groove, and an inner side of said third supporting portion forms a third indented groove, wherein said first indented groove, the second indented groove and the third indented groove form a through hole; or
wherein said main body (11) comprises a first supporting portion (111), a second supporting portion (112) and a third supporting portion (113), wherein an inner side of said first supporting portion and a top side of said second supporting portion form a first indented groove, a top side of said third supporting portion has a second indented groove, wherein said first indented groove and said second indented groove form an integrated groove, wherein said third supporting portion forms a base and has a bottom serving as a bottom of said integrated groove, and preferably wherein said chip connectors of the camera module are provided on an inner surface of said second supporting portion or the top side of said third supporting portion.

## Patentansprüche

1. Elektrischer Halter (10; 310) für mindestens ein Kameramodul, der einen lichtempfindlichen Chip (30; 330) umfasst, umfassend:
ein Hauptkörper (11; 311); und
eine Schaltungsanordnung (12; 313), die in den Hauptkörper integriert ist, wobei die Schaltungsanordnung (12; 313) zum elektrischen Verbinden mit dem lichtempfindlichen Chip (30; 330) angeordnet ist, und wobei der lichtempfindliche Chip (30; 330) zum Anordnen in der Innenseite des elektrischen Halters geeignet ist und innerhalb des elektrischen Halters positioniert ist;
**dadurch gekennzeichnet, dass** die Schaltungsanordnung (12; 313) mehrere elektrische Elemente (121; 3132) und mehrere elektrische Leiter (122; 3131) umfasst, wobei die elektrischen Leiter mit den elektrischen Elementen elektrisch verbunden sind, wobei die elektrischen Elemente (121) in den Hauptkörper (11) eingebettet sind; und wobei mehrere motorleitende Elemente (133; 3122) auf der oberen Oberfläche des Hauptkörpers (11; 311) vorgesehen sind, die mit einem Motor (50; 350) des Kameramoduls elektrisch verbindbar sind.

2. Elektrischer Halter, wie in Anspruch 1 angegeben, ferner umfassend mehrere Verbindungselemente (13), die an dem Hauptkörper (11) vorgesehen und mit der Schaltungsanordnung (12) elektrisch verbunden sind.

3. Elektrischer Halter, wie in Anspruch 1 angegeben, wobei der elektrische Halter (10) mehrere Verbindungselemente (13) umfasst, die an dem Hauptkörper (11) vorgesehen sind, wobei die Verbindungselemente zum elektrischen Verbinden mindestens einer Leitung, die sich von dem lichtempfindlichen Chip nach COB-Typ erstreckt, angeordnet sind; oder
wobei der Hauptkörper (11) ein Durchgangsloch (100) zum Aufnehmen des lichtempfindlichen Chips (30) darin aufweist; oder
wobei der elektrische Halter eine eingerückte Nut aufweist, wobei der lichtempfindliche Chip (30) in der eingerückten Nut installiert ist.

4. Elektrischer Halter (10), wie in Anspruch 2 angegeben, wobei der elektrische Halter ferner mehrere elektronische Komponenten (80) umfasst, die auf einer Oberfläche des Hauptkörpers (11) in hervorstehender Weise vorgesehen sind, wobei jede der elektronischen Komponenten aus einer Gruppe ausgewählt wird, die aus Widerstand, Kapazität, Transistorkonverter, Diode und Treiberchip besteht.

5. Elektrischer Halter (10), wie in Anspruch 1 angegeben, ferner umfassend einen Linsenträger zum Tragen einer optischen Linse des Kameramoduls, wobei der Hauptkörper einen ersten Stützabschnitt (111) aufweist, der den Linsenträger trägt, und die Schaltungsanordnung in den Hauptkörper (11) eingebettet ist, und
vorzugsweise wobei die Schaltungsanordnung erweitert und in den Hauptkörper eingebettet ist, wobei der Linsenträger über Verbindungselemente durch ein Mittel, ausgewählt aus der Gruppe bestehend aus Löten, anisotroper leitfähiger Paste, Ultraschallpresse, UV-Belichtung, Röntgenbelichtung, leitfähigem Klebstoff und Heißpressen, elektrisch mit dem Hauptkörper verbunden ist.

6. Elektrischer Halter (10), wie in Anspruch 2 angegeben,
wobei die Verbindungselemente (13) Chipverbinder sind, die elektrisch mit der Schaltungsanordnung (12) verbunden sind, um sie elektrisch mit dem lichtempfindlichen Chip (30) zu verbinden, wobei die lichtempfindlichen Chip über die Chipverbinder durch ein Mittel, ausgewählt aus der Gruppe bestehend aus Löten, anisotroper leitfähiger Paste, Ultraschallpresse, UV-Belichtung, Röntgenbelichtung, leitfähigem Klebstoff und Heißpressen, elektrisch mit der Schaltungsanordnung verbunden ist, oder
wobei die Verbindungselemente (13) Platinenverbinder sind, die elektrisch mit der Schaltungsanordnung (12) verbunden sind, um sie elektrisch mit einer flexiblen Leiterplatte (20) des Kameramoduls zu verbinden, wobei die flexible Leiterplatte über die Platinenverbinder durch ein Mittel, ausgewählt aus der Gruppe bestehend aus Löten, anisotroper leitfähiger Paste, Ultraschallpresse, UV-Belichtung, Röntgenbelichtung, leitfähigem Klebstoff und Heißpressen, elektrisch mit der Schaltungsanordnung verbunden ist, oder
wobei die Verbindungselemente (13) mehrere verschiedene Verbinder zum elektrischen Verbinden verschiedener elektronischer Komponenten des Kameramoduls mit der Schaltungsanordnung (12) umfassen, wobei das elektrische Verbindungsverfahren zwischen den verschiedenen Verbindern und der Schaltungsanordnung aus der Gruppe, bestehend aus Löten, anisotroper leitfähiger Paste, Ultraschallpresse, UV-Belichtung, Röntgenbelichtung, leitfähigem Klebstoff, Heißpressen usw., ausgewählt ist,
und vorzugsweise wobei die Verbindungselemente als Schweißungspad oder Stift ausgeführt sein können.

7. Elektrischer Halter (10), wie in Anspruch 1 bis 6 angegeben, wobei der elektrische Halter einen ersten Stützabschnitt (111) und einen zweiten Stützabschnitt (112) umfasst, wobei eine Innenseite des ersten Stützabschnitts und eine Oberseite des zweiten Stützabschnitts jeweils eine erste eingerückte Nut bilden, während der zweite Stützabschnitt eine zweite eingerückte Nut aufweist.

8. Elektrischer Halter (10), wie in Anspruch 7 angegeben, wobei der Hauptkörper einen dritten Stützabschnitt (113) umfasst, wobei sich der dritte Stützabschnitt von dem zweiten Stützabschnitt nach innen erstreckt, wobei die Chipverbinder auf einer oberen Oberfläche des dritten Stützabschnitts, zum elektrischen Verbinden mit dem lichtempfindlichen Chip (30), vorgesehen sind; oder
wobei der Hauptkörper (11) einen ersten Stützabschnitt (111), einen zweiten Stützabschnitt (112) und einen dritten Stützabschnitt (113) umfasst, wobei der dritte Stützabschnitt entsprechend dem zweiten Stützabschnitt nach innen eingerückt ist, wobei eine Innenseite des ersten Stützabschnitts und eine Oberseite des zweiten Stützabschnitts jeweils eine erste eingerückte Nut bilden, eine Oberseite des dritten Stützabschnitts eine zweite eingerückte Nut aufweist, und eine Innenseite des dritten Stützabschnitts weist eine dritte eingerückte Nut aufweist, wobei die erste eingerückte Nut, die zweite eingerückte Nut und die dritte eingerückte Nut ein Durchgangsloch bilden; oder wobei der Hauptkörper (11) einen ersten Stützabschnitt (111), einen zweiten Stützabschnitt (112) und einen dritten Stützabschnitt (113) umfasst, wobei eine Innenseite des ersten Stützabschnitts und eine Oberseite des zweiten Stützabschnitts jeweils eine erste eingerückte Nut bilden, eine Oberseite des dritten Stützabschnitts eine zweite eingerückte Nut aufweist, wobei die erste eingerückte Nut und die zweite eingerückte Nut eine integrierte Nut bilden, wobei der dritte Stützabschnitt eine Basis bildet und einen Boden hat, der als Boden der integrierten Nut dient, und vorzugsweise wobei die Chipverbinder des Kameramoduls auf einer Innenfläche des zweiten Stützabschnitts oder der Oberseite des dritten Stützabschnitts vorgesehen sind.

9. Elektrischer Halter (10), wie in Anspruch 7 angegeben, wobei eine Innenseite des zweiten Stützabschnitts (112) eine zweite eingerückte Nut aufweist, wobei der lichtempfindliche Chip an der zweiten eingerückten Nut vorgesehen ist.

10. Elektrischer Halter (10), wie in Anspruch 1 angegeben, wobei das Kameramodul ein Zoomkameramodul ist, das mit dem elektrischen Halter eingearbeitet werden soll.

11. Elektrischer Halter (10), wie in Anspruch 10 angegeben, wobei der elektrische Halter mehrere Verbindungselemente (13) umfasst, wobei die Verbindungselemente mit der Schaltungsanordnung (12) elektrisch verbunden sind.

12. Elektrischer Halter (10), wie in Anspruch 11 angegeben, wobei jedes der elektrischen Elemente aus der Gruppe ausgewählt ist, die aus Widerstand, Kapazität, Transistor, Wandler, Diode, Treiberchip usw. besteht, und vorzugsweise wobei der elektrische Halter ferner mehrere elektronische Komponenten (80) umfasst, die auf einer Oberfläche des Hauptkörpers (11) in hervorstehender Weise vorgesehen sind, wobei jede der elektronischen Komponenten aus einer Gruppe ausgewählt ist, die aus Widerstand, Kapazität, Transistorkonverter, Diode und Treiberchip besteht.

13. Elektrischer Halter (10), wie in Anspruch 11 angegeben,
wobei die Verbindungselemente (13) Chipverbinder sind, die elektrisch mit der Schaltungsanordnung (12), zum elektrischen Verbinden mit dem lichtempfindlichen Chip (30), verbunden sind, wobei die lichtempfindlichen Chip über die Chipverbinder durch ein Mittel, ausgewählt aus die Gruppe bestehend aus Löten, anisotroper leitfähiger Paste, Ultraschallpresse, UV-Belichtung, Röntgenbelichtung, leitfähigem Klebstoff und Heißpressen, elektrisch mit der Schaltungsanordnung verbunden ist; oder
wobei die Verbindungselemente (13) Platinenverbinder sind, die elektrisch mit der Schaltungsanordnung (12), zum elektrischen Verbinden mit einer flexiblen Leiterplatte (20) des Kameramoduls, verbunden sind, wobei der Hauptkörper (11) über die Platinenverbinder durch ein Mittel, ausgewählt aus der Gruppe bestehend aus Löten, anisotroper leitfähiger Paste, Ultraschallpresse, UV-Belichtung, Röntgenbelichtung, leitfähigem Klebstoff und Heißpressen, elektrisch mit der flexiblen Leiterplatte verbunden ist; oder
wobei die Verbindungselemente (13) mehrere verschiedene Verbinder zum elektrischen Verbinden verschiedener elektronischer Komponenten (80) des Kameramoduls mit der Schaltungsanordnung (12) umfassen, wobei das elektrische Verbindungsverfahren zwischen den verschiedenen Verbindern und der Schaltungsanordnung aus der Gruppe, bestehend aus Löten, anisotroper leitfähiger Paste, Ultraschallpresse, UV-Belichtung, Röntgenbelichtung, leitfähigem Klebstoff, Heißpressen usw., ausgewählt ist; oder
wobei die Verbindungselemente (13) mehrere Treiberverbinder zum elektrischen Verbinden eines elektrischen Halters des Kameramoduls mit der Schaltungsanordnung umfassen, wobei das elektrische Verbindungsverfahren zwischen den Treiberverbindern und der Schaltungsanordnung aus der Gruppe, bestehend aus Löten, anisotroper leitfähiger Paste, Ultraschallpresse, UV-Belichtung, Röntgenbelichtung, leitfähigem Klebstoff, Heißpressen usw., ausgewählt ist;
und vorzugsweise wobei die Verbindungselemente als Schweißungspad oder Stift ausgeführt sein können.

14. Elektrischer Halter (10), wie in Anspruch 10-13 angegeben, wobei der Hauptkörper (11) einen ersten Stützabschnitt (111) und einen zweiten Stützabschnitt (112) umfasst, wobei eine Innenseite des ersten Stützabschnitts und eine Oberseite des zweiten Stützabschnitts jeweils eine erste eingerückte Nut bilden, während der zweite Stützabschnitt eine zweite eingerückte Nut aufweist.

15. Elektrischer Halter (10), wie in Anspruch 14 angegeben, wobei die Chipverbinder des Kameramoduls an einer Innenfläche des zweiten Stützabschnitts (112) vorgesehen sind; oder wobei eine Innenseite des zweiten Stützabschnitts (112) eine zweite eingerückte Nut aufweist, wobei der lichtempfindliche Chip an der zweiten eingerückten Nut vorgesehen ist.

16. Elektrischer Halter (10), wie in Anspruch 14 angegeben,
wobei der Hauptkörper (11) einen dritten Stützabschnitt (113) umfasst, wobei sich der dritte Stützabschnitt von dem zweiten Stützabschnitt nach innen erstreckt, wobei die Chipverbinder auf einer oberen Oberfläche des dritten Stützabschnitts, zum elektrischen Verbinden mit dem lichtempfindlichen Chip, vorgesehen sind; oder
wobei der Hauptkörper (11) ferner einen dritten Stützabschnitt (113) umfasst, wobei der dritte Stützabschnitt entsprechend dem zweiten Stützabschnitt nach innen eingerückt ist, wobei eine Oberseite des dritten Stützabschnitts eine zweite eingerückte Nut bildet, und eine Innenseite des dritten Stützabschnitts eine dritte eingerückte Nut bildet, wobei die erste eingerückte Nut, die zweite eingerückte Nut und die dritte eingerückte Nut ein Durchgangsloch bilden; oder
wobei der Hauptkörper (11) einen ersten Stützabschnitt (111), einen zweiten Stützabschnitt (112) und einen dritten Stützabschnitt (113) umfasst, wobei eine Innenseite des ersten Stützabschnitts und eine Oberseite des zweiten Stützabschnitts jeweils eine erste eingerückte Nut bilden, eine Oberseite des dritten Stützabschnitts eine zweite eingerückte Nut aufweist, wobei die erste eingerückte Nut und die zweite eingerückte Nut eine integrierte Nut bilden, wobei der dritte Stützabschnitt eine Basis bildet und einen Boden hat, der als Boden der integrierten Nut dient, und vorzugsweise wobei die Chipverbinder des Kameramoduls auf einer Innenfläche des zweiten Stützabschnitts oder der Oberseite des dritten Stützabschnitts vorgesehen sind.

## Revendications

1. Support électrique (10;310) pour au moins un module de caméra qui comprend une puce photosensible (30;330), comprenant:
un corps principal (11;311); et
un agencement de circuit (12;313) intégré dans ledit corps principal, dans lequel ledit agencement de circuit (12; 313) est agencé pour se connecter électriquement à la puce photosensible (30;330), et dans lequel la puce photosensible (30; 330) est adaptée pour être disposée à l'intérieur du support électrique et est positionnée à l'intérieur du support électrique;
**caractérisé en ce que** ledit agencement de circuit (12; 313) comprend une pluralité d'éléments électriques (121; 3132) et une pluralité de conducteurs électriques (122;3131), dans lequel lesdits conducteurs électriques sont connectés électriquement auxdits éléments électriques, dans lequel lesdits éléments électriques (121) sont intégrés dans ledit corps principal (11); et dans lequel une pluralité d'éléments conducteurs de moteur (133; 3122) sont prévus sur la surface supérieure du corps principal (11;311), qui peuvent être connectés électriquement à un moteur (50; 350) du module de caméra.

2. Support électrique selon la revendication 1, comprenant en outre une pluralité d'éléments de connexion (13) prévus au niveau dudit corps principal (11) et connectés électriquement audit agencement de circuit (12).

3. Support électrique selon la revendication 1, dans lequel le support électrique (10) comprend une pluralité d'éléments de connexion (13) prévus au niveau dudit corps principal (11), dans lequel lesdits éléments de connexion sont agencés pour connecter électriquement au moins un conducteur étendu de la puce photosensible par type COB; ou
dans lequel ledit corps principal (11) a un trou traversant (100) pour y recevoir la puce photosensible (30); ou
dans lequel ledit support électrique a une rainure dentelée, dans lequel ladite puce photosensible (30) est installée dans la rainure dentelée.

4. Support électrique (10) selon la revendication 2, dans lequel le support électrique comprend en outre une pluralité de composants électroniques (80) disposés sur une surface dudit corps principal (11) de manière saillante, dans lequel chacun des composants électroniques est sélectionné dans un groupe consistant en résistance, capacité, convertisseur à transistor, diode et puce pilote.

5. Support électrique (10) selon la revendication 1, comprenant en outre un support de lentille pour supporter une lentille optique du module de caméra, dans lequel ledit corps principal a une première partie de support (111) qui supporte ledit support de lentille et ledit agencement de circuit est intégré dans ledit corps principal (11), et
de préférence dans lequel ledit agencement de circuit est étendu et intégré dans ledit corps principal, dans lequel ledit support de lentille est connecté électriquement audit corps principal via des éléments de connexion par un moyen sélectionné dans le groupe consistant en soudure, pâte conductrice anisotrope, presse ultrasonique, exposition aux UV, exposition aux rayons X, colle conductrice et pressage à chaud.

6. Support électrique (10) selon la revendication 2, dans lequel lesdits éléments de connexion (13) sont des connecteurs de puce connectés électriquement audit agencement de circuit (12) pour se connecter électriquement à la puce photosensible (30), dans lequel lesdites puces photosensibles sont connectées électriquement audit agencement de circuit via lesdits connecteurs de puce par un moyen sélectionné dans le groupe consistant en soudure, pâte conductrice anisotrope, presse ultrasonique, exposition aux UV, exposition aux rayons X, colle conductrice et pressage à chaud, ou
dans lequel lesdits éléments de connexion (13) sont des connecteurs de carte connectés électriquement audit agencement de circuit (12) pour se connecter électriquement à une carte de circuit imprimé flexible (20) du module de caméra, dans lequel ladite carte de circuit imprimé flexible est électriquement connectée audit agencement de circuit via ledit connecteurs de carte par un moyen sélectionné dans le groupe consistant en soudure, pâte conductrice anisotrope, presse ultrasonique, exposition aux UV, exposition aux rayons X, colle conductrice et pressage à chaud, ou
dans lequel lesdits éléments de connexion (13) comprennent une pluralité de connecteurs différents pour connecter électriquement différents composants électroniques dudit module de caméra avec ledit agencement de circuits (12), dans lequel ledit procédé de connexion électrique entre lesdits différents connecteurs et ledit agencement de circuits est sélectionné dans le groupe comprenant soudure, pâte conductrice anisotrope, presse ultrasonique, exposition aux UV, exposition aux rayons X, colle conductrice, pressage à chaud, et etc.,
et de préférence dans lequel lesdits éléments de connexion peuvent être réalisés sous la forme d'un plot de connexion ou d'une broche.

7. Support électrique (10) selon les revendications 1 à 6, dans lequel ledit support électrique comprend une première partie de support (111) et une seconde partie de support (112), dans lequel un côté intérieur de ladite première partie de support et un côté supérieur de la seconde partie de support forment une première rainure dentelée tandis que ladite seconde partie de support a une seconde rainure dentelée.

8. Support électrique (10) selon la revendication 7, dans lequel ledit corps principal comprend une troisième partie de support (113), dans lequel ladite troisième partie de support est étendue vers l'intérieur à partir de ladite seconde partie de support, dans lequel lesdits connecteurs de puce sont prévus sur une surface supérieure de ladite troisième partie de support pour connexion électrique avec la puce photosensible (30); ou
dans lequel ledit corps principal (11) comprend une première partie de support (111), une seconde partie de support (112) et une troisième partie de support (113), dans lequel ladite troisième partie de support est indentée vers l'intérieur correspondant à ladite seconde partie de support, dans lequel un côté intérieur de ladite première partie de support et un côté supérieur de ladite deuxième partie de support forment une première rainure dentelée, un côté supérieur de ladite troisième partie de support a une deuxième rainure dentelée, et un côté intérieur de ladite troisième partie de support a une troisième rainure dentelée, dans lequel ladite première rainure dentelée, ladite deuxième rainure dentelée et ladite troisième rainure dentelée forment un trou traversant; ou
dans lequel ledit corps principal (11) comprend une première partie de support (111), une seconde partie de support (112)et une troisième partie de support (113), dans lequel un côté intérieur de ladite première partie de support et un côté supérieur de ladite deuxième partie de support forment un première rainure dentelée, un côté supérieur de ladite troisième partie de support a une deuxième rainure dentelée, dans laquelle ladite première rainure dentelée et ladite deuxième rainure dentelée forment une rainure intégrée, dans lequel ladite troisième partie support forme une base et a un fond servant de fond de ladite rainure intégrée, et de préférence dans lequel lesdits connecteurs de puce du module de caméra sont prévus sur une surface intérieure de ladite seconde partie de support ou sur le côté supérieur de ladite troisième partie de support.

9. Support électrique (10) selon la revendication 7, dans lequel dans un côté intérieur de ladite deuxième partie de support (112) a une deuxième rainure dentelée, dans lequel ladite puce photosensible est prévue au niveau de ladite deuxième rainure dentelée.

10. Support électrique (10) selon la revendication 1, dans lequel ledit module de caméra est un module de caméra zoom à incorporer avec le support électrique.

11. Support électrique (10) selon la revendication 10, dans lequel ledit support électrique comprend une pluralité d'éléments de connexion (13), dans lequel lesdits éléments de connexion sont connectés électriquement audit agencement de circuit (12).

12. Support électrique (10) selon la revendication 11, dans lequel chacun desdits éléments électriques est sélectionné dans le groupe comprenant un groupe comprenant résistance, capacité, convertisseur à transistor, diode, puce pilote, et etc., et de préférence dans lequel le support électrique comprend en outre une pluralité de composants électroniques (80) prévues sur une surface dudit corps principal (11) de manière saillante, dans lequel chacun des composants électroniques est sélectionné dans un groupe constitant en résistance, capacité, convertisseur à transistor, diode et puce pilote.

13. Support électrique (10) selon la revendication 11, dans lequel lesdits éléments de connexion (13) sont des connecteurs de puce connectés électriquement audit agencement de circuit (12) pour se connecter électriquement à la puce photosensible (30), dans lequel lesdites puces photosensibles sont connectées électriquement audit agencement de circuit via lesdits connecteurs de carte par un moyen sélectionné dans le groupe consistant en soudure, pâte conductrice anisotrope, presse ultrasonique, exposition aux UV, exposition aux rayons X, colle conductrice et pressage à chaud; ou
dans lequel lesdits éléments de connexion (13) sont des connecteurs de carte connectés électriquement audit agencement de circuit (12) pour se connecter électriquement à une carte de circuit imprimé flexible (20) du module de caméra, dans lequel ledit corps principal (11) est connecté électriquement à la carte de circuit flexible via ledit connecteurs de carte par un moyen sélectionné dans le groupe consistant en soudure, pâte conductrice anisotrope, presse ultrasonique, exposition aux UV, exposition aux rayons X, colle conductrice et pressage à chaud; ou
dans lequel lesdits éléments de connexion (13) comprennent une pluralité de connecteurs différents pour connecter électriquement différents composants électroniques (80) dudit module de caméra avec ledit agencement de circuit (12), dans lequel ledit procédé de connexion électrique entre lesdits connecteurs différents et ledit agencement de circuit est sélectionné dans le groupe comprenant soudure, pâte conductrice anisotrope, presse ultrasonique, exposition aux UV, exposition aux rayons X, colle conductrice, pressage à chaud, et etc.; ou
dans lequel lesdits éléments de connexion (13) comprennent une pluralité de connecteurs de pilote pour connecter électriquement un support électrique dudit module de caméra avec ledit agencement de circuit, dans lequel ledit procédé de connexion électrique entre lesdits connecteurs de pilote et ledit agencement de circuit est sélectionné dans le groupe comprenant soudure, pâte conductrice anisotrope, presse ultrasonique, exposition aux UV, exposition aux rayons X, colle conductrice, pressage à chaud, et etc.;
et de préférence dans lequel lesdits éléments de connexion peuvent être réalisés sous la forme d'un plot de connexion ou d'une broche.

14. Support électrique (10) selon les revendications 10 à 13, dans lequel ledit corps principal (11) comprend une première partie de support (111) et une seconde partie de support (112), dans lequel un côté intérieur de ladite première partie de support et un côté supérieur de ladite seconde partie de support forment une première rainure dentelée tandis que ladite seconde partie de support a une seconde rainure dentelée.

15. Support électrique (10) selon la revendication 14, dans lequel lesdits connecteurs de puce du module de caméra sont pourvus d'une surface intérieure de ladite seconde partie de support (112); ou
dans lequel un côté intérieur de ladite deuxième partie de support (112) a une deuxième rainure dentelée, dans lequel ladite puce photosensible est prévue au niveau de ladite deuxième rainure dentelée.

16. Support électrique (10) selon la revendication 14, dans lequel ledit corps principal (11) comprend une troisième partie de support (113), dans lequel ladite troisième partie de support est étendue vers l'intérieur à partir de ladite seconde partie de support, dans lequel lesdits connecteurs de puce sont prévus sur une surface supérieure de ladite troisième partie de support pour connexion électrique avec la puce photosensible; ou
dans lequel ledit corps principal (11) comprend en outre une troisième partie de support (113), dans lequel ladite troisième partie de support est indentée vers l'intérieur correspondant à ladite seconde partie de support, dans lequel un côté supérieur de ladite troisième partie de support forme une seconde rainure en retrait, et un côté intérieur de ladite troisième partie de support forme une troisième rainure dentelée, dans laquelle ladite première rainure dentelée, la deuxième rainure dentelée et la troisième rainure dentelée forment un trou traversant; ou
dans lequel ledit corps principal (11) comprend une première partie de support (111), une seconde partie de support (112) et une troisième partie de support (113), dans lequel un côté intérieur de ladite première partie de support et un côté supérieur de ladite deuxième partie de support forment un première rainure dentelée, un côté supérieur de ladite troisième partie de support a une deuxième rainure dentelée, dans laquelle ladite première rainure dentelée et ladite deuxième rainure dentelée forment une rainure intégrée, dans lequel ladite troisième partie support forme une base et a un fond servant de fond de ladite rainure intégrée, et de préférence dans lequel lesdits connecteurs de puce du module de caméra sont prévus sur une surface intérieure de ladite deuxième partie de support ou sur le côté supérieur de ladite troisième partie de support.
